# EUROPEAN PATENT SPECIFICATION

(11) **EP 3 557 641 B1**
(45) Date of publication and mention of the grant of the patent: **23.11.2022**
(21) Application number: 18824922.1
(22) Date of filing: 28.05.2018
(51) Int. Cl.: H01L 51/46, H01L 31/0256

(54) **ORGANIC SOLAR CELL**
ORGANISCHE SOLARZELLE
CELLULE SOLAIRE ORGANIQUE

(30) Priority: 27.06.2017 KR 20170081181
(43) Date of publication of application: 23.10.2019
(73) Proprietor: LG Chem, Ltd., Seoul 07336 (KR)
(72) Inventor: CHOI, Doowhan, Daejeon 34122 (KR); LEE, Jiyoung, Daejeon 34122 (KR); KIM, Ji Hoon, Daejeon 34122 (KR); LIM, Bogyu, Daejeon 34122 (KR); JANG, Songrim, Daejeon 34122 (KR)
(74) Representative: Hoffmann Eitle
(86) International application number: PCT/KR2018/006021
(87) International publication number: WO 2019/004605

(56) References cited:
- KR-A- 20160 075 370
- KR-A- 20170 067 028
- WENCHAO ZHAO ET AL: "Ternary Polymer Solar Cells based on Two Acceptors and One Donor for Achieving 12.2% Efficiency", ADVANCED MATERIALS, vol. 29, no. 2, 3 November 2016 (2016-11-03), page 1604059, XP055648899, DE ISSN: 0935-9648, DOI: 10.1002/adma.201604059
- CHUANFEI WANG ET AL: "Ternary organic solar cells with enhanced open circuit voltage", NANO ENERGY, vol. 37, 3 May 2017 (2017-05-03), pages 24-31, XP055648920, ISSN: 2211-2855, DOI: 10.1016/j.nanoen.2017.04.060
- YUSHENG CHEN ET AL: "Achieving High-Performance Ternary Organic Solar Cells through Tuning Acceptor Alloy", ADVANCED MATERIALS, vol. 29, no. 6, 5 December 2016 (2016-12-05), page 1603154, XP055648908, DE ISSN: 0935-9648, DOI: 10.1002/adma.201603154
- DECHAN ANGMO ET AL: "Fullerene alloy formation and the benefits for efficient printing of ternary blend organic solar cells", JOURNAL OF MATERIALS CHEMISTRY C, vol. 3, no. 21, 7 May 2015 (2015-05-07), pages 5541-5548, XP055648911, ISSN: 2050-7526, DOI: 10.1039/C5TC00781J
- TAO LIU ET AL: "Ternary Organic Solar Cells Based on Two Compatible Nonfullerene Acceptors with Power Conversion Efficiency >10%", ADVANCED MATERIALS, vol. 28, no. 45, 26 September 2016 (2016-09-26), pages 10008-10015, XP055637112, DE ISSN: 0935-9648, DOI: 10.1002/adma.201602570
- LU , H. et al.: "Ternary-Blend Polymer Solar Cells Combining Fullerene and Nonfullerene Acceptors to Synergistically Boost the Photovoltaic Performance", Advanced Materials, vol. 28, no. 43, 2016, pages 9559-9566, XP055565884,
- YUAN, J. et al.: "Narrow Bandgap Conjugated Polymers Based on a High-mobility Polymer Template for Visibly Transparent Photovoltaic Devices", Journal of Materials Chemistry A, vol. 4, no. 44, 2016, pages 17333-17343, XP055565923,
- ZHANG, S. et al.: "A Fluorinated Polythiophene Derivative with Stabilized Backbone Conformation for Highly Efficient Fullerene and Non-filllerene Polymer Solar Cells", Macromolecules, vol. 49, no. 8, 2016, pages 2993-3000, XP055565929,

## Description

### [Technical Field]

This application claims priority to and the benefits of Korean Patent Application No. 10-2017-0081181, filed with the Korean Intellectual Property Office on June 27, 2017.

The present specification relates to an organic solar cell.

### [Background Art]

An organic solar cell is a device capable of directly converting solar energy to electric energy by applying a photovoltaic effect. Solar cells are divided into inorganic solar cells and organic solar cells depending on the materials forming a thin film, and since existing inorganic solar cells already have limits in economic feasibility and material supplies, organic solar cells that are readily processed, inexpensive and have various functions have been highly favored as a long-term alternative energy source.

As an electron acceptor material used in a photoactive layer of an organic solar cell, fullerene-based compounds have been mainly used, and recently, studies on non-fullerene-based compounds capable of changing an absorption area have been actively ongoing.

However, non-fullerene-based compounds exhibit favorable efficiency only in combination with specific electron donor materials, and therefore, overcoming such limitations has been an important challenge. KR 2017 0067028 A and KR 2016 0075370 A describe solar cells with a donor polymer and a fullerene acceptor. CHUANFEI WANG ET AL: NANO ENERGY, vol. 37, pages 24-31 describes a ternary solar cell having a donor polymer, a fullerene acceptor and a non-fullerene acceptor.

### [Disclosure]

### [Technical Problem]

The present specification is directed to providing an organic solar cell.

### [Technical Solution]

The present invention provides an organic solar cell including a first electrode; a second electrode disposed opposite to the first electrode; and one or more organic material layers disposed between the first electrode and the second electrode and including a photoactive layer, wherein the photoactive layer includes an electron donor and an electron acceptor, and the electron acceptor is a dual electron acceptor including both a fullerene-based compound and a non-fullerene-based compound,
wherein the electron donor includes a polymer including a unit represented by the following Chemical Formula 5 of claim 1 or a unit represented by the following Chemical Formula 6 of claim 1, and wherein
the fullerene-based compound and the non-fullerene-based compound have a mass ratio of 1.2:0.8 to 0.5:1.5 when the polymer of the electron donor includes a unit represented by Chemical Formula 5 of claim 1, and wherein the fullerene-based compound and the non-fullerene-based compound have a mass ratio of 1.2:0.8 to 0.2:1.8 when the polymer of the electron donor includes a unit represented by Chemical Formula 6 of claim 1.

### [Advantageous Effects]

An organic solar cell according to the present invention has excellent energy conversion efficiency by using a dual electron acceptor including both a fullerene-based compound and a non-fullerene-based compound as an electron acceptor of a photoactive layer.

### [Description of Drawings]

FIG. 1 is a diagram illustrating an organic solar cell according to one embodiment of the present specification.
FIG. 2 is a diagram presenting voltage-dependent current density of organic solar cells of Example 3, Comparative Example 1 and Comparative Example 2 of the present specification.
FIG. 3 is a diagram presenting voltage-dependent current density of organic solar cells of Example 6, Comparative Example 3 and Comparative Example 4.
FIG. 4 is a diagram presenting an NMR spectrum of Chemical Formula J synthesized in Preparation Example 1.
FIG. 5 is a diagram presenting an NMR spectrum of Chemical Formula J-1 synthesized in Preparation Example 1.
FIG. 6 is a diagram presenting an NMR spectrum of Chemical Formula K synthesized in Preparation Example 1.
FIG. 7 is a diagram presenting a UV-vis absorption spectrum of Polymer 1 synthesized in Preparation Example 1.
FIG. 8 is a diagram presenting a UV-vis absorption spectrum of Polymer 2 synthesized in Preparation Example 2.

### [Reference Numeral]

101: First Electrode
102: Electron Transfer Layer
103: Photoactive Layer
104: Hole Transfer Layer
105: Second Electrode

### [Mode for Disclosure]

Hereinafter, the present specification will be described in more detail.

The present invention provides an organic solar cell including a first electrode; a second electrode disposed opposite to the first electrode; and one or more organic material layers disposed between the first electrode and the second electrode and including a photoactive layer, wherein the photoactive layer includes an electron donor and an electron acceptor, and the electron acceptor is a dual electron acceptor including both a fullerene-based compound and a non-fullerene-based compound,wherein the electron donor includes a polymer including a unit represented by the following Chemical Formula 5 of claim 1 or a unit represented by the following Chemical Formula 6 of claim 1, and whereinthe fullerene-based compound and the non-fullerene-based compound have a mass ratio of 1.2:0.8 to 0.5:1.5 when the polymer of the electron donor includes a unit represented by Chemical Formula 5 of claim 1, and wherein the fullerene-based compound and the non-fullerene-based compound have a mass ratio of 1.2:0.8 to 0.2:1.8 when the polymer of the electron donor includes a unit represented by Chemical Formula 6 of claim 1.

In the present specification, a description of a certain part 'including' certain constituents means capable of further including other constituents, and does not exclude other constituents unless particularly stated on the contrary.

In the present specification, a 'unit' is a repeated structure included in a monomer of a polymer, and means a structure in which the monomer bonds in the polymer by polymerization.

In the present specification, the meaning of 'including a unit' means being included in a main chain in a polymer.

Examples of the substituents are described below, however, the substituents are not limited thereto.

In the present specification, 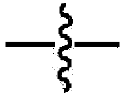 means a site linked to other substituents, monomers or bonding sites.

The term 'substitution' means a hydrogen atom bonding to a carbon atom of a compound is changed to another substituent, and the position of substitution is not limited as long as it is a position at which the hydrogen atom is substituted, that is, a position at which a substituent can substitute, and when two or more substituents substitute, the two or more substituents may be the same as or different from each other.

The term `substituted or unsubstituted' in the present specification means being substituted with one or more substituents selected from the group consisting of deuterium; a halogen group; a nitrile group; a nitro group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkenyl group; a substituted or unsubstituted aryl group; and a substituted or unsubstituted heterocyclic group, or being substituted with a substituent linking two or more substituents among the substituents illustrated above, or having no substituents. For example, 'a substituent linking two or more substituents' may include a biphenyl group. In other words, a biphenyl group may be an aryl group, or interpreted as a substituent linking two phenyl groups.

In the present specification, examples of the halogen group include fluorine, chlorine, bromine or iodine.

In the present specification, the alkyl group may be linear or branched, and although not particularly limited thereto, the number of carbon atoms is preferably from 1 to 50. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylhexyl, 4-methylhexyl, 5-methylhexyl and the like, but are not limited thereto.

In the present specification, the cycloalkyl group is not particularly limited, but preferably has 3 to 60 carbon atoms, and specific examples thereof may include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl and the like, but are not limited thereto.

In the present specification, the alkoxy group may be linear, branched or cyclic. The number of carbon atoms of the alkoxy group is not particularly limited, but is preferably from 1 to 20. Specific examples thereof may include methoxy, ethoxy, n-propoxy, isopropoxy, i-propyloxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, the alkenyl group may be linear or branched, and although not particularly limited thereto, the number of carbon atoms is preferably from 2 to 40. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

In the present specification, when the aryl group is a monocyclic aryl group, the number of carbon atoms is not particularly limited, but is preferably from 6 to 25. Specific examples of the monocyclic aryl group may include a phenyl group, a biphenyl group, a terphenyl group and the like, but are not limited thereto.

In the present specification, when the aryl group is a polycyclic aryl group, the number of carbon atoms is not particularly limited, but is preferably from 10 to 24. Specific examples of the polycyclic aryl group may include a naphthyl group, an anthracenyl group, a phenanthryl group, a pyrenyl group, a perylenyl group, a chrysenyl group, a fluorenyl group and the like, but are not limited thereto.

In the present specification, the fluorenyl group may be substituted, and adjacent substituents may bond to each other to form a ring.

In the present specification, the arylene group means the aryl group having two bonding sites, that is, a divalent group. Descriptions on the aryl group provided above may be applied thereto except for these each being divalent.

In the present specification, the heterocyclic group is a group including one or more atoms that are not carbon, that is, heteroatoms, and specifically, the heteroatom may include one or more atoms selected from the group consisting of O, N, Se, S and the like. The number of carbon atoms of the heterocyclic group is not particularly limited, but is preferably from 2 to 60. Examples of the heterocyclic group may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazoline group, a quinoxalinyl group, a phthalazinyl group, an isoquinoline group, an indole group, a carbazole group, a benzoxazole group, a benzimidazole group, a benzothiazole group, a benzocarbazole group, a benzothiophene group, a dibenzothiophene group, a benzofuranyl group, a phenanthroline group, a thiazolyl group, an isoxazolyl group, an oxadiazolyl group, a thiadiazolyl group, a phenothiazinyl group, a dibenzofuranyl group and the like, but are not limited thereto.

In the present specification, the aryl group of the aryloxy group is the same as the examples of the aryl group described above. Specifically, examples of the aryloxy group may include phenoxy, p-tolyloxy, m-tolyloxy, 3,5-dimethyl-phenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, 9-phenanthryloxy and the like, examples of the arylthioxy group may include a phenylthioxy group, a 2-methylphenylthioxy group, a 4-tert-butylphenylthioxy group and the like, and examples of the arylsulfoxy group may include a benzenesulfoxy group, a p-toluenesulfoxy group and the like, however, the aryloxy group, the arylthioxy group and the arylsulfoxy group are not limited thereto.

In the present specification, the 'fullerene-based compound' means a soccer ball-shaped molecule formed by carbon atoms forming pentagonal and hexagonal shapes being linked to each other.

In the present specification, the 'non-fullerene-based compound' means a compound that is not the fullerene-based compound.

The fullerene-based compound is a material commonly used as an electron acceptor of an organic solar cell, but only absorbs light in an ultraviolet region, and aggregates together. Accordingly, using a fullerene-based compound alone as an electron acceptor of an organic solar cell affects morphology of a photoactive layer leading to a disadvantage of reducing a device lifetime.

On the other hand, a non-fullerene-based compound may be transformed into various structures as well as capable of controlling an energy band gap, and therefore, may perform a role of improving device lifetime and efficiency. However, there is still a limit that it is activated with only a small number of electron donor materials.

By using both a fullerene-based compound and a non-fullerene-based compound, the organic solar cell according to one embodiment of the present specification may enhance efficiency of the organic solar cell by complementing each other's disadvantages.

In one embodiment of the present specification, the fullerene-based compound may be any one of the following [6,6]-phenyl-C₆₁-butyric acid methyl ester (PC₆₁BM), [6,6]-phenyl-C₇₁-butyric acid methyl ester (PC₇₁BM), mono-o-quino-dimethane C₆₀ (mono-oQDMC₆₀), bis-o-quino-dimethane C₆₀ (bis-oQDMC₆₀), indene-C₆₀-bis-adduct (ICBA) and bis-[6,6]-phenyl-C₆₁-butyric acid methyl ester (bis-PCBM).

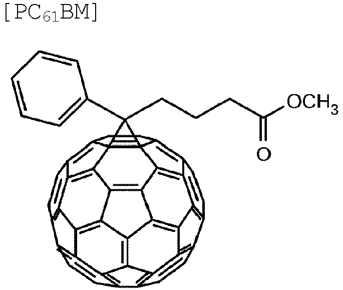

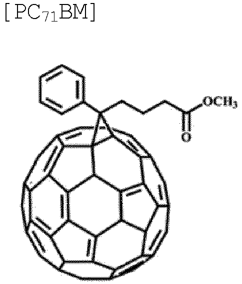

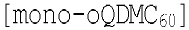

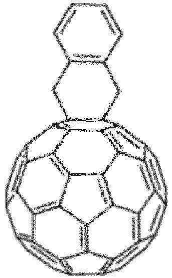

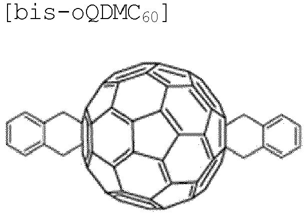

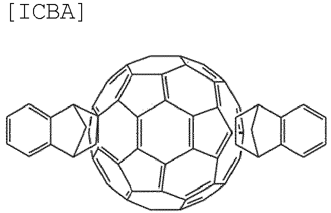

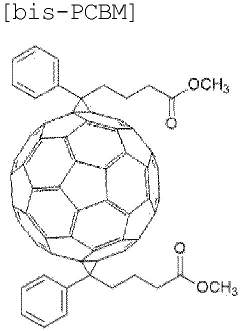

In one embodiment of the present specification, the non-fullerene-based compound may be represented by the following Chemical Formula A.

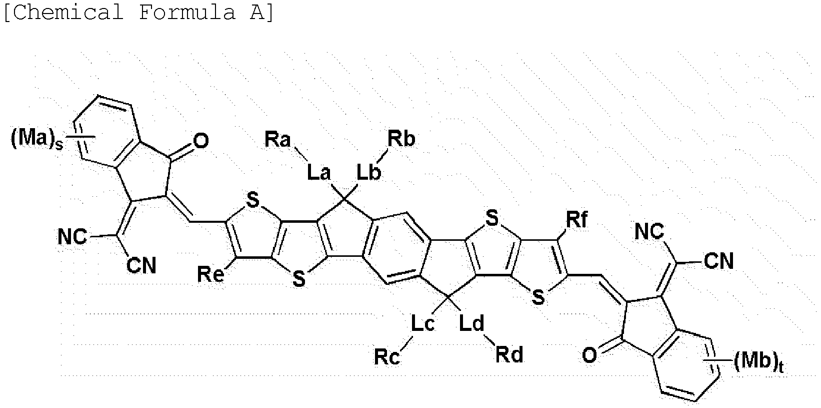

In Chemical Formula A,
Ra to Rf are the same as or different from each other, and each independently hydrogen; or a substituted or unsubstituted alkyl group,
La to Ld are the same as or different from each other, and each independently a substituted or unsubstituted arylene group; or a substituted or unsubstituted divalent heterocyclic group,
Ma and Mb are the same as or different from each other, and each independently hydrogen; a halogen group; or a substituted or unsubstituted alkyl group,
s and t are the same as or different from each other, and each independently an integer of 0 to 2, and
when s or t is each 2, structures in the parentheses are the same as each other.

In one embodiment of the present specification, Ra to Rd are each an alkyl group.

In another embodiment, Ra to Rd are each an alkyl group having 1 to 30 carbon atoms.

In another embodiment, Ra to Rd are each an alkyl group having 1 to 10 carbon atoms.

In one embodiment of the present specification, Re and Rf are hydrogen.

In one embodiment of the present specification, La to Ld are each an arylene group.

In another embodiment, La to Ld are each an arylene group having 6 to 25 carbon atoms.

In another embodiment, La to Ld are a phenylene group.

In another embodiment, La to Ld are each a divalent heterocyclic group.

In another embodiment, La to Ld are each a divalent heterocyclic group having 2 to 30 carbon atoms.

In another embodiment, La to Ld are each a divalent heterocyclic group having 2 to 10 carbon atoms.

In another embodiment, La to Ld are a divalent thiophene group.

In one embodiment of the present specification, Ma and Mb are hydrogen.

In another embodiment, Ma and Mb are each an alkyl group.

In another embodiment, Ma and Mb are each an alkyl group having 1 to 10 carbon atoms.

In another embodiment, Ma and Mb are a methyl group.

In another embodiment, Ma and Mb are each a halogen group.

In another embodiment, Ma and Mb are fluorine.

In one embodiment of the present specification, s and t are 0.

In another embodiment, s and t are 1.

In another embodiment, s and t are 2.

In one embodiment of the present specification, the non-fullerene-based compound is any one of the following Chemical Formulae A-1 to A-5.

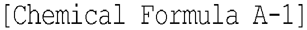

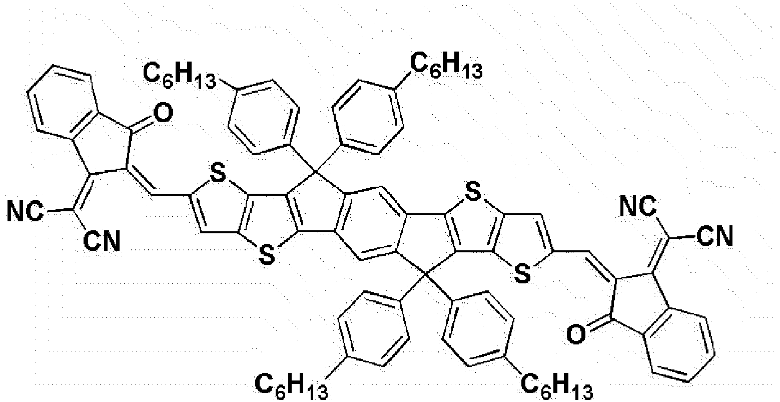

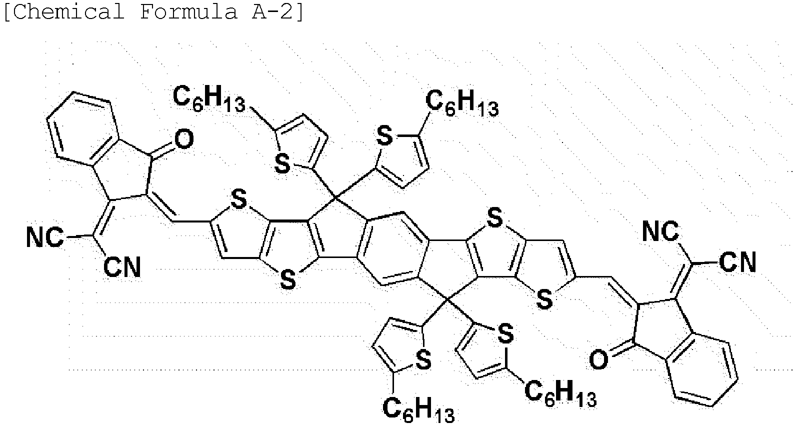

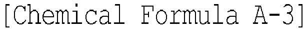

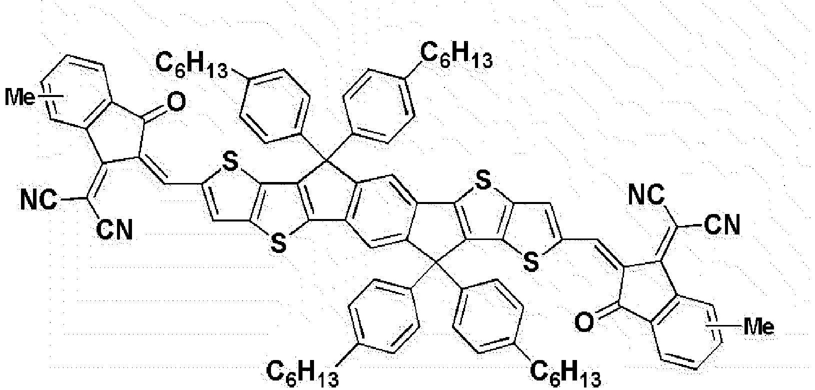

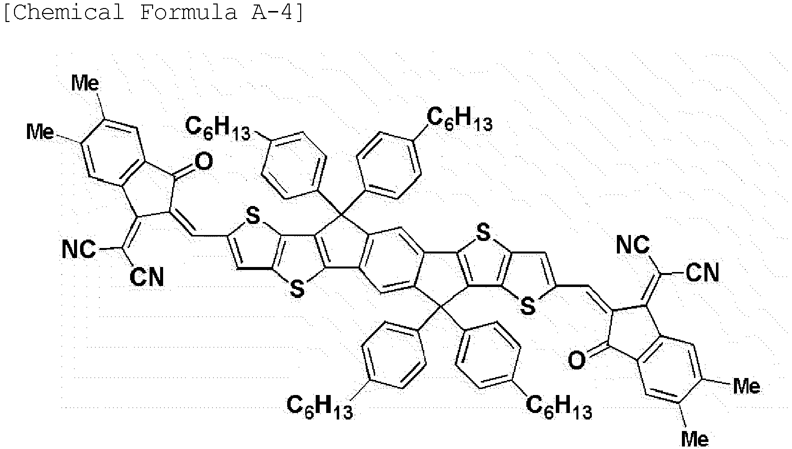

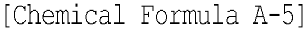

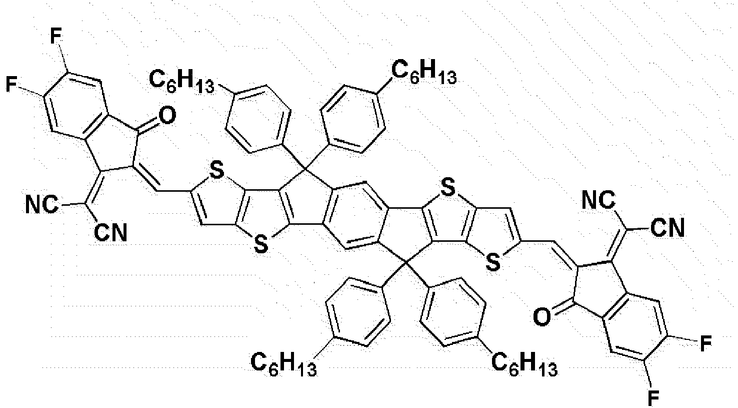

In the present specification, Me means a methyl group.

In another embodiment of the present specification, the non-fullerene-based compound is the compound represented by Chemical Formula A-1.

In the present invention, the electron donor includes a polymer including a unit represented by the Chemical Formula 5 of claim 1 or a unit represented by the Chemical Formula 6 of claim 1.

In one embodiment of the present invention, the polymer includes a unit represented by the following Chemical Formula 5.

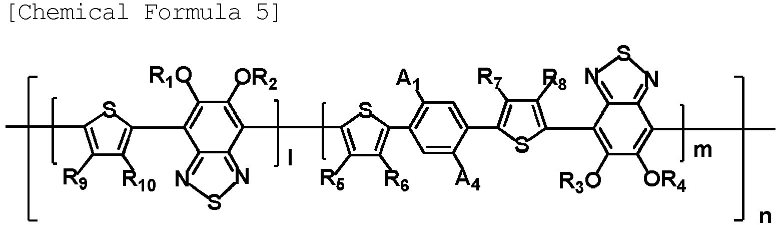

In Chemical Formula 5, R₁ to R₄ are the same as or different from each other, and each independently a substituted or unsubstituted alkyl group; or a substituted or unsubstituted aryl group; R₅ to R₁₀ are the same as or different from each other, and
each independently hydrogen; deuterium; a halogen group; a nitrile group; a nitro group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkenyl group; a substituted or unsubstituted aryl group; or a substituted or unsubstituted heterocyclic group;
A₁ and A₄ are the same as or different from each other, and each independently hydrogen, fluorine or chlorine, and at least one of A₁ and A₄ is fluorine or chlorine, 1 is, as a mole fraction, a real number of 0<1<1,
m is, as a mole fraction, a real number of 0<m<1, 1+m=1, and
n is, as a unit repetition number, an integer of 1 to 10,000.

In one embodiment of the present specification, R₁ to R₄ are an alkyl group having 1 to 30 carbon atoms.

In another embodiment, R₁ to R₄ are an alkyl group having 1 to 15 carbon atoms.

In one embodiment of the present specification, R₅ to R₁₀ are hydrogen.

In one embodiment of the present specification, A₁ and A₄ are fluorine.

In one embodiment of the present specification, 1 is 0.5.

In one embodiment of the present specification, m is 0.5.

In one embodiment of the present specification, the polymer includes a unit represented by the following Chemical Formula 5-1.

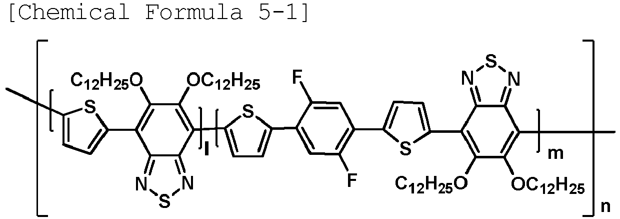

In Chemical Formula 5-1, 1, m and n have the same definitions as in Chemical Formula 5.

In one embodiment of the present invention, the polymer includes a unit represented by the following Chemical Formula 6.

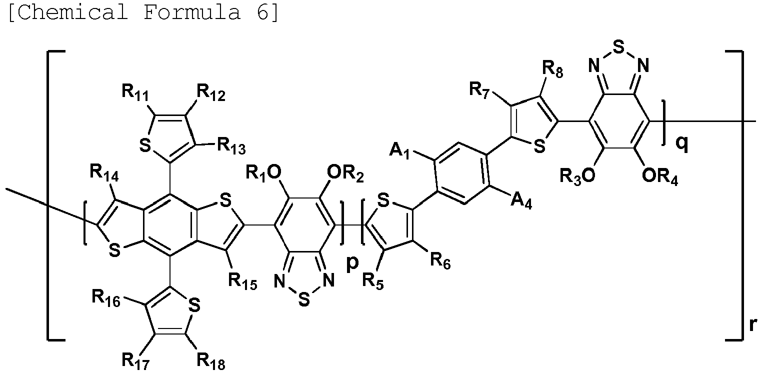

In Chemical Formula 6, R₁ to R₄ are the same as or different from each other, and each independently a substituted or unsubstituted alkyl group; or a substituted or unsubstituted aryl group;
R₅ to R₈ and R₁₁ to R₁₈ are the same as or different from each other, and each independently hydrogen; deuterium; a halogen group; a nitrile group; a nitro group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkenyl group; a substituted or unsubstituted aryl group; or a substituted or unsubstituted heterocyclic group;
A₁ and A₄ are the same as or different from each other,
and each independently hydrogen, fluorine or chlorine, and at least one of A₁ and A₄ is fluorine or chlorine,
p is, as a mole fraction, a real number of 0<p<1,
q is, as a mole fraction, a real number of 0<q<1, p+q=1, and
r is, as a unit repetition number, an integer of 1 to 10,000.

In one embodiment of the present specification, R₁ to R₄ are each an alkyl group having 1 to 30 carbon atoms.

In one embodiment of the present specification, R₁ to R₄ are each an alkyl group having 1 to 15 carbon atoms.

In one embodiment of the present specification, R₁₁ and R₁₈ are each an alkyl group having 1 to 30 carbon atoms.

In one embodiment of the present specification, R₁₁ and R₁₈ are each an alkyl group having 1 to 15 carbon atoms.

In one embodiment of the present specification, R₅ to R₈ and R₁₂ to R₁₇ are hydrogen.

In one embodiment of the present specification, A₁ and A₄ are fluorine.

In one embodiment of the present specification, p is 0.5.

In one embodiment of the present specification, q is 0.5.

In one embodiment of the present specification, the polymer includes a unit represented by the following Chemical Formula 6-1.

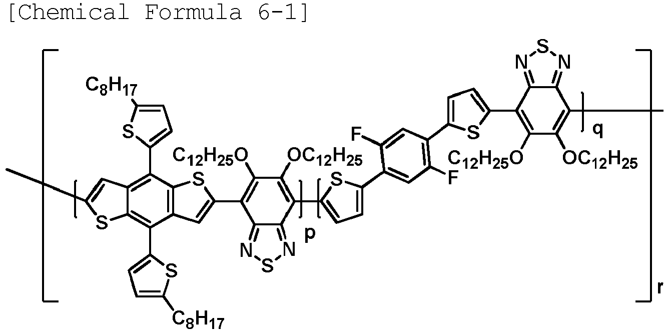

In Chemical Formula 6-1, p, q and r have the same definitions as in Chemical Formula 6.

In one embodiment of the present specification, the electron donor is the polymer represented by Chemical Formula 5, the fullerene-based compound of the electron acceptor is PC₇₁BM, and the non-fullerene-based compound of the electron acceptor may be the compound represented by Chemical Formula A-1.

In the present invention, when the electron donor is the polymer represented by Chemical Formula 5, the fullerene-based compound and the non-fullerene-based compound have a mass ratio of 1.2:0.8 to 0.5:1.5, preferably 1.2:0.8 to 0.8:1.2.

In one embodiment of the present specification, the electron donor is the polymer represented by Chemical Formula 6, the fullerene-based compound of the electron acceptor is PC₇₁BM, and the non-fullerene-based compound of the electron acceptor may be the compound represented by Chemical Formula A-1.

In the present invention, when the electron donor is the polymer represented by Chemical Formula 6, the fullerene-based compound and the non-fullerene-based compound have a mass ratio of 1.2:0.8 to 0.2:1.8, preferably 1.2:0.8 to 0.4:1.6, and more preferably 0.8:1.2 to 0.4:1.6.

In one embodiment of the present specification, the electron donor and the electron acceptor have a mass ratio of 1:1 to 1:4. The ratio is preferably from 1:1.5 to 1:2.5, and more preferably from 1:1.8 to 1:2.2.

In one embodiment of the present specification, the polymer is a random polymer. In addition, when the polymer is a random polymer, solubility is enhanced, which is economically effective cost-wise in terms of a device manufacturing process.

In one embodiment of the present specification, an end group of the polymer is a substituted or unsubstituted heterocyclic group; or a substituted or unsubstituted aryl group.

In one embodiment of the present specification, an end group of the polymer is a 4-(trifluoromethyl)phenyl group.

In one embodiment of the present specification, an end group of the polymer is a bromo-thiophene group.

In another embodiment, an end group of the polymer is a trifluoro-benzene group.

According to one embodiment of the present specification, the polymer preferably has a number average molecular weight of 5,000 g/mol to 1,000,000 g/mol.

According to one embodiment of the present specification, the polymer may have molecular weight distribution of 1 to 10. The polymer preferably has molecular weight distribution of 1 to 3.

Electrical properties and mechanical properties become better as the molecular weight distribution decreases and the number average molecular weight increases.

In addition, the number average molecular weight is preferably 100,000 g/mol or less so that a solution coating method is favorably used by having solubility of certain level or higher.

The polymer may be prepared by introducing monomers of each unit with Pd₂(dba)₃ and P(o-tolyl)₃ with chlorobenzene as a solvent, and polymerizing the result using a microwave reactor.

The polymer according to the present specification may be prepared through a multi-step chemical reaction. After preparing monomers through an alkylation reaction, a Grignard reaction, a Suzuki coupling reaction, a Stille coupling reaction and the like, final polymers may be prepared through a carbon-carbon coupling reaction such as a Stille coupling reaction. When a substituent to introduce is a boronic acid or boronic ester compound, the polymer may be prepared through a Suzuki coupling reaction, and when a substituent to introduce is a tributyltin or trimethyltin compound, the polymer may be prepared through a Stille coupling reaction, however, the preparation is not limited thereto.

An organic solar cell according to one embodiment of the present specification includes a first electrode, a photoactive layer and a second electrode. the organic solar cell may further include a substrate, a hole transfer layer and/or an electron transfer layer.

In one embodiment of the present specification, when the organic solar cell receives photons from an external light source, electrons and holes are generated between an electron donor and an electron acceptor. The generated holes are transferred to an anode through an electron donor layer.

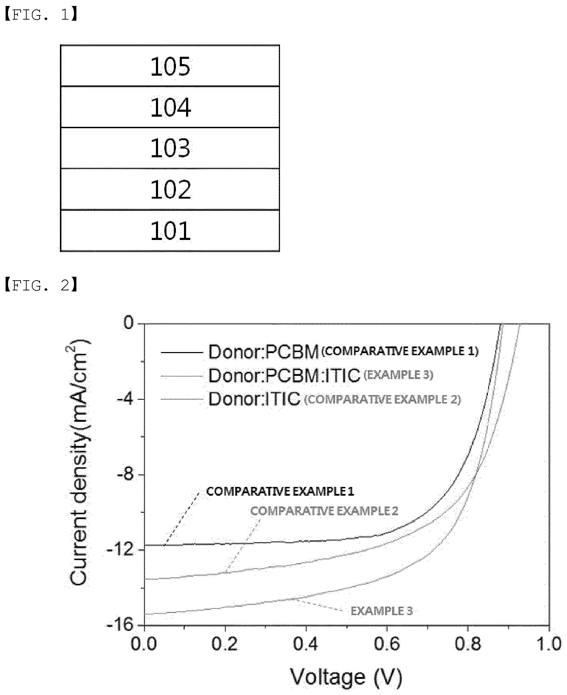

FIG. 1 is a diagram illustrating an organic solar cell according to one embodiment of the present specification including a first electrode (101), an electron transfer layer (102), a photoactive layer (103), a hole transfer layer (104) and a second electrode (105).

In one embodiment of the present specification, the organic solar cell may further include additional organic material layers. The organic solar cell may reduce the number of organic material layers by using organic materials having various functions at the same time.

In one embodiment of the present specification, in the organic solar cell, the layers may be arranged in the order of a cathode, a photoactive layer and an anode, or may also be arranged in the order of an anode, a photoactive layer and a cathode, however, the disposition is not limited thereto.

In another embodiment, in the organic solar cell, the layers may be arranged in the order of an anode, a hole transfer layer, a photoactive layer, an electron transfer layer and a cathode, or may also be arranged in the order of a cathode, an electron transfer layer, a photoactive layer, a hole transfer layer and an anode, however, the disposition is not limited thereto.

In one embodiment of the present specification, the organic solar cell has a normal structure. In the normal structure, the layers may be laminated in the order of a substrate, a first electrode, a hole transfer layer, an organic material layer including a photoactive layer, an electron transfer layer and a second electrode.

In one embodiment of the present specification, the organic solar cell has an inverted structure. In the inverted structure, the layers may be laminated in the order of a substrate, a first electrode, an electron transfer layer, an organic material layer including a photoactive layer, a hole transfer layer and a second electrode.

In one embodiment of the present specification, the first electrode is an anode, and the second electrode is a cathode. In another embodiment, the first electrode is a cathode, and the second electrode is an anode.

In the present specification, a description of one member being placed 'on' another member includes not only a case of the one member adjoining the another member but a case of still another member being present between the two members.

In the present specification, an energy level means magnitude of energy. Accordingly, even when an energy level is expressed in a negative (-) direction from a vacuum level, the energy level is interpreted to mean an absolute value of the corresponding energy value. For example, a HOMO energy level means a distance from a vacuum level to a highest occupied molecular orbital. In addition, a LUMO energy level means a distance from a vacuum level to a lowest unoccupied molecular orbital.

In one embodiment of the present specification, the organic solar cell has a tandem structure. In this case, the organic solar cell may include two or more layers of photoactive layers. The organic solar cell according to one embodiment of the present specification may have a photoactive layer in one, or two or more layers.

In another embodiment, a buffer layer may be disposed between a photoactive layer and a hole transfer layer, or between a photoactive layer and an electron transfer layer. Herein, a hole injection layer may be further disposed between an anode and the hole transfer layer. In addition, an electron injection layer may be further disposed between a cathode and the electron transfer layer.

In one embodiment of the present specification, the electron donor and the electron acceptor form a bulk heterojunction (BHJ).

A bulk heterojunction means an electron donor material and an electron acceptor material being mixed together in a photoactive layer.

In one embodiment of the present specification, the photoactive layer further includes an additive.

In one embodiment of the present specification, the additive has a molecular weight of 50 g/mol to 300 g/mol.

In another embodiment, the additive is an organic material having a boiling point of 30°C to 300°C.

In the present specification, the organic material means a material including at least one or more carbon atoms.

In one embodiment, the additive may further include one or more types of additives among additives selected from the group consisting of 1,8-diiodooctane (DIO), 1-chloronaphthalene (1-CN), diphenyl ether (DPE), octanedithiol and tetrabromothiophene.

In one embodiment of the present specification, the photoactive layer has a bilayer structure including an n-type organic material layer and a p-type organic material layer, and the p-type organic material layer includes the polymer.

The substrate in the present specification may include a glass substrate or a transparent plastic substrate having excellent transparency, surface smoothness, handling easiness and water resistance, but is not limited thereto, and substrates typically used in organic solar cells may be used without limit. Specific examples thereof include glass, polyethylene terphthalate (PET), polyethylene naphthalate (PEN), polypropylene (PP), polyimide (PI), triacetyl cellulose (TAC) and the like, but are not limited thereto.

A material of the first electrode may include a material that is transparent and has excellent conductivity, however, the material is not limited thereto. Examples thereof may include metals such as vanadium, chromium, copper, zinc or gold, or alloys thereof; metal oxides such as zinc oxide, indium oxide, indium tin oxide (ITO) or indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, and the like, but are not limited thereto.

A method of forming the first electrode is not particularly limited, however, a method of, for example, sputtering, E-beam, thermal deposition, spin coating, screen printing, inkjet printing, doctor blade or gravure printing may be used.

When forming the first electrode on a substrate, the result may go through processes of cleaning, dehydrating and modifying to be hydrophilic.

For example, after a patterned ITO substrate is cleaned with a cleaning agent, acetone and isopropyl alcohol (IPA) in consecutive order, the ITO substrate is dried for 1 minute to 30 minutes at 100°C to 150°C, preferably for 10 minutes at 120°C, on a heating plate in order to dehydrate, and when the substrate is completely cleaned, the surface of the substrate is modified to be hydrophilic.

Through the surface modification such as above, the junctional surface potential may be maintained at a level suitable as surface potential of a photoactive layer. In addition, when a surface is modified, a polymer thin film may be readily formed on a first electrode, and the quality of the thin film may be improved.

Preprocessing technologies for the first electrode include a) a surface oxidation method using parallel plate discharge, b) a method of oxidizing the surface through ozone generated using UV rays in a vacuum state, and c) an oxidation method using oxygen radicals generated by plasma.

One of the methods described above may be selected depending on the condition of the first electrode or the substrate. However, it is commonly preferred to prevent the leave of oxygen on the surface of the first electrode or the substrate and to suppress the remaining of moisture and organic materials as much as possible, no matter which method is used. Practical effects of the preprocessing may be maximized in this case.

As a specific example, a method of oxidizing the surface through ozone generated using UV may be used. Herein, a patterned ITO substrate may be fully dried by baking the patterned ITO substrate on a hot plate after being ultrasonic cleaned, and the patterned ITO substrate is introduced into a chamber and then may be cleaned by the ozone generated by reacting oxygen gas with UV light using a UV lamp.

However, the method of surface modification of the patterned ITO substrate in the present specification is not particularly limited, and any method oxidizing a substrate may be used.

The second electrode may include a metal having small work function, but is not limited thereto. Specific examples thereof may include metals such as magnesium, calcium, sodium, potassium, titanium, indium, yttrium, lithium, gadolinium, aluminum, silver, tin and lead, or alloys thereof; or multilayer-structured materials such as LiF/Al, LiO₂/Al, LiF/Fe, Al:Li, Al:BaF₂ and Al:BaF₂:Ba, but are not limited thereto.

The second electrode may be formed by being deposited inside a thermal depositor having a vacuum degree of 5×10⁻⁷ torr or less, however, the formation is not limited to this method.

The hole transfer layer and/or the electron transfer layer play a role of efficiently transferring the electrons and the holes separated in a photoactive layer to an electrode, and the material is not particularly limited.

The hole transfer layer material may include poly(3,4-ethylenedioxythiophene) doped with poly(styrenesulfonic acid) (PEDOT:PSS), molybdenum oxide (MoOₓ); vanadium oxide (V₂O₅); nickel oxide (NiO); tungsten oxide (WOₓ) and the like, but is not limited thereto.

The electron transfer layer material may include electron-extracting metal oxides, and may specifically include a metal complex of 8-hydroxyquinoline; a complex including Alq₃; a metal complex including Liq; LiF; Ca; titanium oxide (TiOₓ); zinc oxide (ZnO); cesium carbonate (Cs₂CO₃), and the like, but is not limited thereto.

The photoactive layer may be formed by dissolving a photoactive material such as an electron donor and/or an electron acceptor in an organic solvent, and then applying the solution using a method such as spin coating, dip coating, screen printing, spray coating, doctor blade or brush painting, however, the method is not limited thereto.

Hereinafter, the present specification will be described in detail with reference to examples in order to specifically describe the present specification. However, examples according to the present specification may be modified to various different forms, and the scope of the present specification is not construed as being limited to the examples described below. The examples of the present specification are provided in order to more fully describe the present specification to those having average knowledge in the art.

### <Preparation Example 1: Synthesis of Polymer 1>

### (1) Synthesis of Chemical Formula J

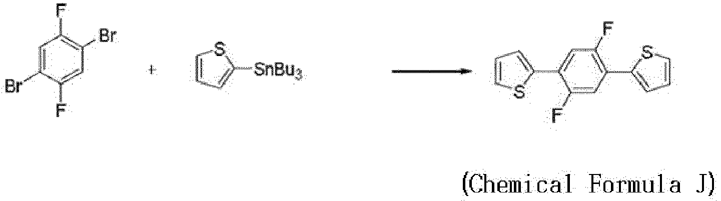

After introducing toluene to two starting materials and adding 0.05 equivalents of tetrakis(triphenylphosphine)palladium(0) (Pd(PPh₃)₄) thereto, the result was stirred for 15 hours at 80°C, and the reaction solution gradually changed to black. This was worked up, dried with magnesium sulfate, and then recrystallized to obtain Chemical Formula J (white powder, 4.3 g).

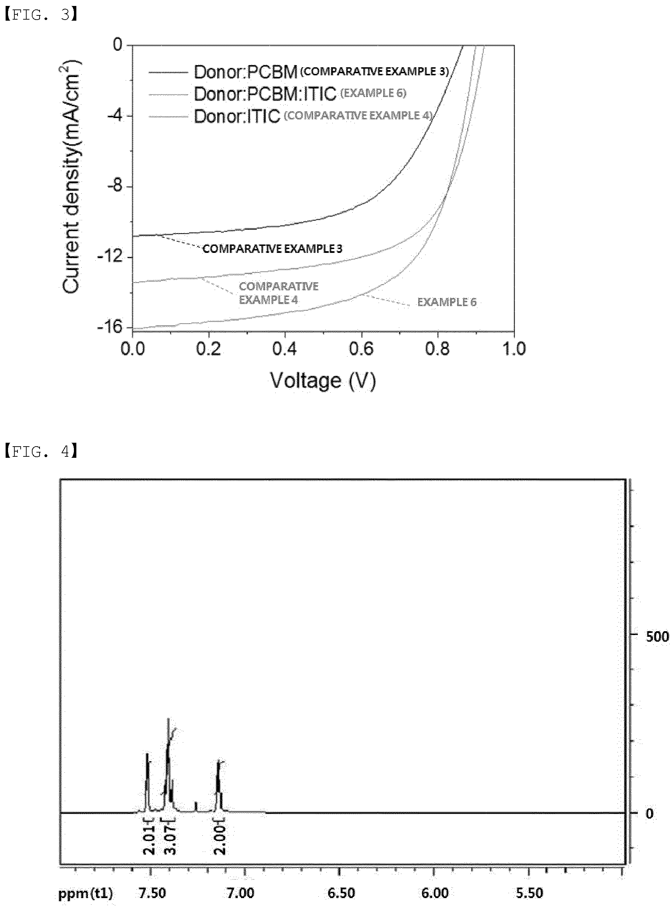

An NMR spectrum of the synthesized Chemical Formula J is presented in FIG. 4.

### (2) Synthesis of Chemical Formula J-1

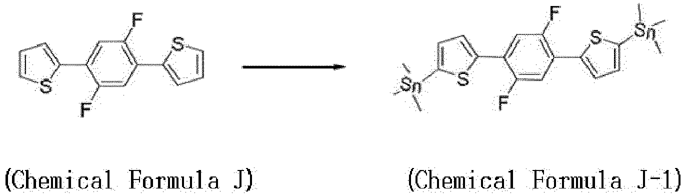

After dissolving the prepared Chemical Formula J in tetrahydrofuran (THF) and lowering the temperature to -78°C, 2.1 equivalents of n-butyllithium (n-BuLi) was added thereto, and the result was stirred for 30 minutes. After that, the result was further stirred for 1 hour at room temperature, and the solution color changed to yellow. The temperature was lowered to -78°C again, 2.1 equivalents of trimethyltin chloride was added thereto, and the result was stirred for 12 hours while slowly raising the temperature to room temperature. After 12 hours, the solution color changed to ocher, and when crystallizing the result after work up, Chemical Formula J-1 in a glossy plate-type yellow solid form was obtained.

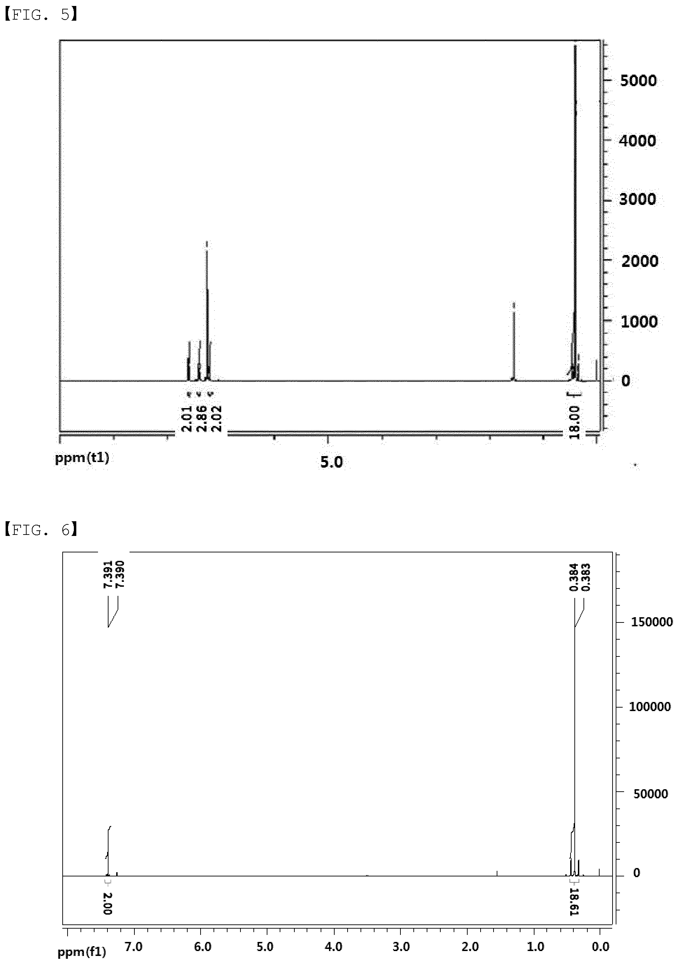

An NMR spectrum of the synthesized Chemical Formula J-1 is presented in FIG. 5.

### (3) Synthesis of Chemical Formula K

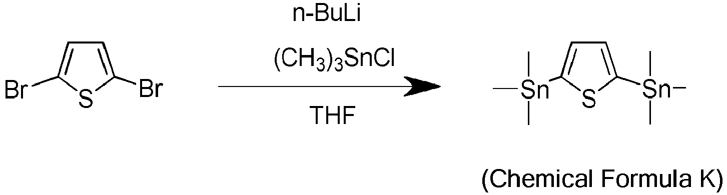

After introducing and dissolving 2,5-dibromothiophene (9.68 g, 40.0 mmol) in 200 ml of tetrahydrofuran (THF), the temperature was lowered to -78°C. At this temperature, 1.6 M n-butyllithium (n-BuLi) dissolved in hexane (55 ml, 88 mmol) was slowly added thereto, and the result was stirred for 1 hour. After that, 1 M trimethyltin chloride dissolved in THF (100 ml, 100 mmol) was introduced thereto at once, the temperature was raised to room temperature, and the result was stirred for 12 hours. This solution was poured into ice, extracted three times with diethyl ether and washed three times with water, and residual water was removed using magnesium sulfate (MgSO₄). With the remaining solution, the solvent was removed under decompression, and the result was recrystallized with methanol to obtain Chemical Formula K in a white solid form.

Yield: 73.1 %

FIG. 6 presents an NMR spectrum of the synthesized Chemical Formula K.

### (4) Synthesis of Chemical Formula L

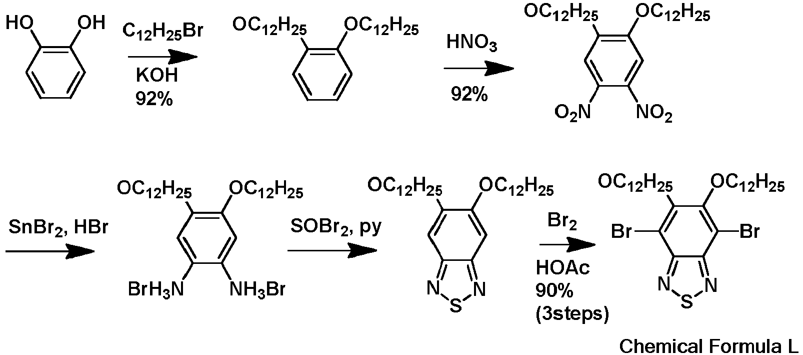

A compound of Chemical Formula L was synthesized based on JOURNAL OF POLYMER SCIENCE PART A: POLYMER CHEMISTRY 2011, 49, 4387-4397 4389.

### (5) Synthesis of Polymer 1

The following Polymer 1 was prepared by, with chlorobenzene as a solvent, introducing the monomers of Chemical Formulae J-1, K and L with Pd₂(dba)₃ and P(o-tolyl)₃, and polymerizing the result using a microwave reactor.

### [Polymer 1]

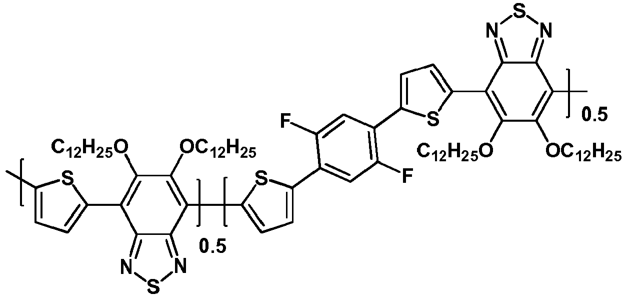

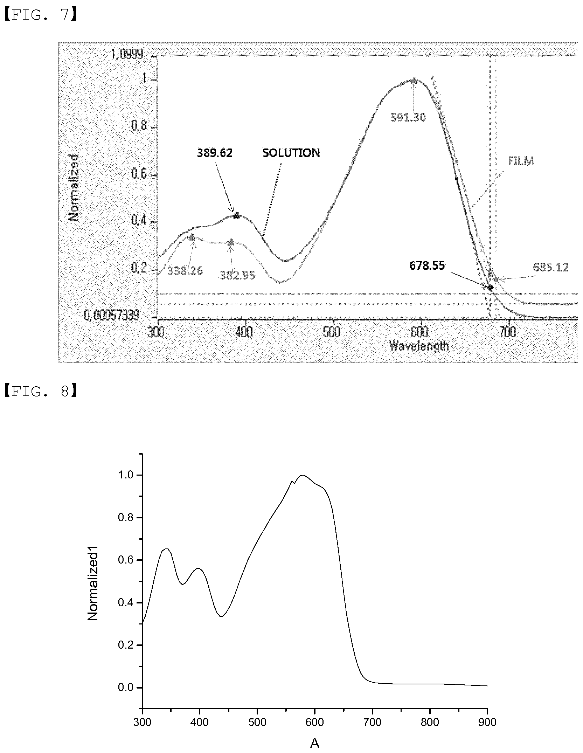

Properties of Polymer 1 are as in the following Table 1, and a UV-vis absorption spectrum of Polymer 1 is presented in FIG. 7.

**[Table 1]**

| | Polymer 1 |
|---|---|
| Number Average Molecular Weight (Mn) | 21315 g/mol |
| PDI (Molecular Weight Distribution: Mw/Mn) | 1.17 |
| Color of Solid | Violet-Blue |
| UV max (Solution State) | 591 nm |
| UV max (Film State) | 591 nm |
| UV edge (Film) | 685 nm |
| Band Gap | 1.81 eV |
| CV [Eox] | 1.18 V (Vs Ag/AgCl) |
| HOMO Energy Level | -5.53 eV |
| LUMO Energy Level | -3.72 eV |

### <Preparation Example 2: Synthesis of Polymer 2>

### (1) Synthesis of Chemical Formula M

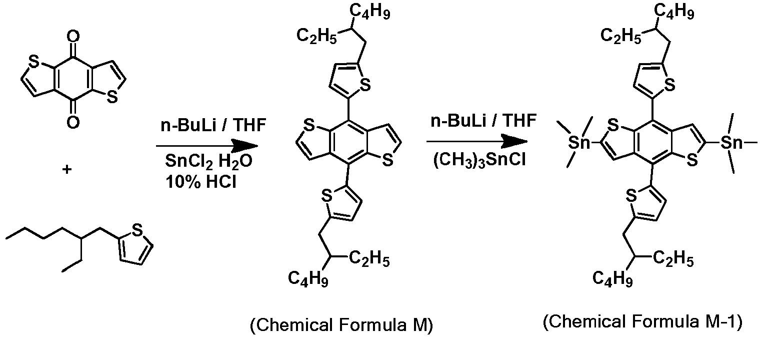

After introducing and dissolving 2-(2-ethylhexyl)thiophene (10.0 g, 59.4 mmol) in 500 ml of tetrahydrofuran (THF), the temperature was lowered to -78°C. At this temperature, 2.5 M n-butyllithium (n-BuLi) dissolved in hexane (24.0 ml, 59.4 mmol) was slowly added thereto, and the result was stirred for 30 minutes. After that, the temperature was raised up to 0°C, and after stirring the result for 1 hour in this state, 4,8-dihydrobenzo[1,2-b:4,5-b']dithiophene-4,8-dione (3.3 g, 14.8 mmol) was introduced thereto at once, and the result was stirred for 3 hours 50°C. After lowering the temperature of this solution to room temperature, tin(II)chloride dehydrate (26 g) and 1 M HCl (56 ml) were added thereto, and the result was further stirred for 3 hours. Ice was poured into this solution, and the result was extracted twice with diethyl ether and washed twice with water, and residual water was removed using magnesium sulfate (MgSO₄). With the remaining solution, the solvent was removed under decompression, and Chemical Formula M in a yellow high density liquid form was obtained through silica column. (Yield: 64%)

### (2) Synthesis of Chemical Formula M-1

After introducing and dissolving the compound of Chemical Formula M (3.9 g, 7.59 mmol) in 100 ml of tetrahydrofuran (THF), the temperature was lowered to 0°C. At this temperature, 1.6 M n-butyllithium (n-BuLi) dissolved in hexane (10.4 ml, 16.7 mmol) was slowly added thereto, and the result was stirred for 1 hour at room temperature. To this solution, 1 M trimethyltin chloride dissolved in THF (22.7 ml, 22.7 mmol) was introduced thereto at once, and the result was stirred for 2 hours. Water was poured into this solution, and the result was extracted twice with diethyl ether and washed twice with water, and residual water was removed using magnesium sulfate (MgSO₄). With the remaining solution, the solvent was removed under decompression, and the result was recrystallized with ethanol to obtain Chemical Formula M-1 in a light yellow crystalline form. (Yield: 87%)

### (3) Synthesis of Polymer 2

The following Polymer 2 was prepared by, with chlorobenzene as a solvent, introducing Chemical Formulae J-1 and L synthesized in Preparation Example 1 and the monomer of Chemical Formula M-1 with Pd₂(dba)₃ and P(o-tolyl)₃, and polymerizing the result using a microwave reactor.

### [Polymer 2]

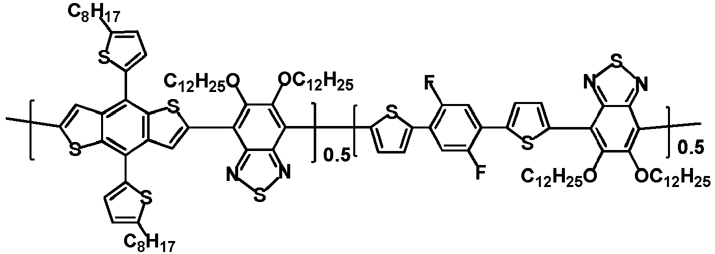

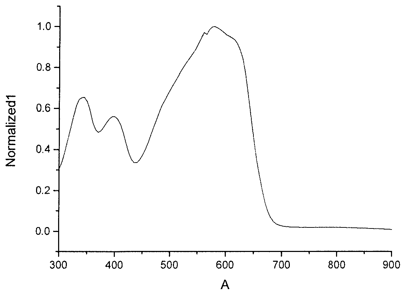

FIG. 8 is a diagram presenting a UV-vis absorption spectrum of Polymer 2.

### <Example: Manufacture of Organic Solar Cell>

### Example 1 (not forming part of the present invention).

ITO was formed on a substrate as a first electrode, and ZnO was spin-coated on the ITO to form an electron transfer layer. Then, a composite solution was prepared by dissolving 10 mg of Polymer 1 synthesized in Preparation Example 1 as an electron donor, and 20 mg of PC₇₁BM (Nano-C Inc, [NANO-C-PCBM-SF] 70PCBM) and the following ITIC (Solarmer Materials Inc.) as an electron acceptor in 1.5 ml of chlorobenzene (CB). Herein, a mass ratio of PC₇₁BM and ITIC was employed as 1.6:0.4. The composite solution was spin coated on the electron transfer layer to form a photoactive layer, and MoO₃ was deposited to a thickness of 10 nm on the photoactive layer to form a hole transfer layer. Lastly, in order to form a second electrode, Ag was deposited to a thickness of 100 nm using a thermal evaporator under vacuum of 3×10⁻⁸ torr to manufacture an organic solar cell.

### [ITIC]

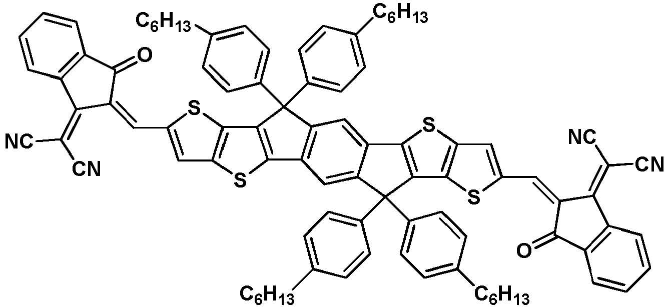

### Example 2.

An organic solar cell was manufactured in the same manner as in Example 1 except that the mass ratio of PC₇₁BM and ITIC was employed as 1.2:0.8.

### Example 3.

An organic solar cell was manufactured in the same manner as in Example 1 except that the mass ratio of PC₇₁BM and ITIC was employed as 0.8:1.2.

### Example 4.

An organic solar cell was manufactured in the same manner as in Example 1 except that the mass ratio of PC₇₁BM and ITIC was employed as 0.5:1.5.

### Example 5.

An organic solar cell was manufactured in the same manner as in Example 1 except that Polymer 2 synthesized in Preparation Example 2 was used instead of Polymer 1 as the electron donor, and the mass ratio of PC₇₁BM and ITIC was employed as 1.2:0.8.

### Example 6.

An organic solar cell was manufactured in the same manner as in Example 5 except that the mass ratio of PC₇₁BM and ITIC was employed as 0.8:1.2.

### Example 7.

An organic solar cell was manufactured in the same manner as in Example 5 except that the mass ratio of PC₇₁BM and ITIC was employed as 0.4:1.6.

### Example 8.

An organic solar cell was manufactured in the same manner as in Example 5 except that the mass ratio of PC₇₁BM and ITIC was employed as 0.2:1.8.

### Comparative Example 1.

An organic solar cell was manufactured in the same manner as in Example 1 except that only PC₇₁BM was used as the electron acceptor material.

### Comparative Example 2.

An organic solar cell was manufactured in the same manner as in Example 1 except that only ITIC was used as the electron acceptor material.

### Comparative Example 3.

An organic solar cell was manufactured in the same manner as in Example 5 except that only PC₇₁BM was used as the electron acceptor material.

### Comparative Example 4.

An organic solar cell was manufactured in the same manner as in Example 5 except that only ITIC was used as the electron acceptor material.

Photoelectric conversion properties of the organic solar cells manufactured in Examples 1 to 8 and Comparative Examples 1 to 4 were measured under a 100 mW/cm² (AM 1.5) condition, and the results are shown in the following Table 2. Note that in Table 2 below, Example 1 is not forming part of the present invention.

**[Table 2]**

| | Mass Ratio | | | V_{OC} (V) | Jsc (mA/cm²) | FF | PCE (%) |
|---|---|---|---|---|---|---|---|
| | Donor | Acceptor | | | | | |
| | | PC₇₁BM | ITIC | | | | |
| Example 1 | 1 | 1.6 | 0.4 | 0.875 | 13.797 | 0.670 | 8.09 |
| Example 2 | 1 | 1.2 | 0.8 | 0.890 | 15.042 | 0.653 | 8.74 |
| Example 3 | 1 | 0.8 | 1.2 | 0.896 | 15.665 | 0.636 | 8.94 |
| Example 4 | 1 | 0.5 | 1.5 | 0.899 | 15.448 | 0.584 | 8.11 |
| Example 5 | 1 | 1.2 | 0.8 | 0.896 | 14.437 | 0.623 | 8.05 |
| Example 6 | 1 | 0.8 | 1.2 | 0.898 | 15.984 | 0.630 | 9.04 |
| Example 7 | 1 | 0.4 | 1.6 | 0.899 | 15.603 | 0.623 | 8.73 |
| Example 8 | 1 | 0.2 | 1.8 | 0.910 | 14.885 | 0.639 | 8.65 |
| Comparative Example 1 | 1 | 2 | 0 | 0.880 | 11.730 | 0.677 | 6.98 |
| Comparative Example 2 | 1 | 0 | 2 | 0.927 | 13.528 | 0.595 | 7.47 |
| Comparative Example 3 | 1 | 2 | 0 | 0.784 | 10.802 | 0.579 | 4.91 |
| Comparative Example 4 | 1 | 0 | 2 | 0.912 | 13.826 | 0.632 | 7.98 |

In Table 2, V_{OC} means an open circuit voltage, J_{SC} means a short-circuit current, FF means a fill factor, and PCE means energy conversion efficiency. The open circuit voltage and the short-circuit current are each an x-axis and a y-axis intercept in the four quadrants of a voltage-current density curve, and as these two values increase, solar cell efficiency is preferably enhanced. In addition, the fill factor is a value dividing the rectangle area that may be drawn inside the curve by the product of the short-circuit current and the open circuit voltage. The energy conversion efficiency may be obtained when these three values are divided by intensity of the irradiated light, and it is preferred as the value is higher. FIG. 2 is a diagram presenting voltage-dependent current density of the organic solar cells of Example 3, Comparative Example 1 and Comparative Example 2. Through FIG. 2, it was seen that, when using Polymer 1 as an electron donor material, efficiency was higher when using PC₇₁BM and ITIC together as an electron acceptor material compared to when using PC₇₁BM or ITIC alone.

FIG. 3 is a diagram presenting voltage-dependent current density of the organic solar cells of Example 6, Comparative Example 3 and Comparative Example 4. Through FIG. 3, it was seen that, when using Polymer 2 as an electron donor material, efficiency was higher when using PC₇₁BM and ITIC together as an electron acceptor material compared to when using PC₇₁BM or ITIC alone.

In addition, through the results of Table 2, it was seen that higher energy conversion efficiency was obtained when using PC₇₁BM and ITIC together as an electron acceptor as in Examples 1 to 8 compared to Comparative Examples 1 to 4 using PC₇₁BM or ITIC alone.

## Claims

1. An organic solar cell comprising:
a first electrode (101);
a second electrode (105) disposed opposite to the first electrode; and
one or more organic material layers disposed between the first electrode and the second electrode and including a photoactive layer (103),
wherein the photoactive layer includes an electron donor and an electron acceptor,
the electron acceptor is a dual electron acceptor including both a fullerene-based compound and a non-fullerene-based compound, and
the electron donor includes a polymer including a unit represented by the following Chemical Formula 5 or a unit represented by the following Chemical Formula 6: 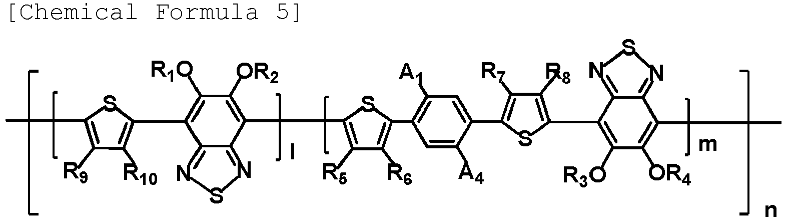
in Chemical Formula 5,
R₁ to R₄ are the same as or different from each other, and each independently a substituted or unsubstituted alkyl group; or a substituted or unsubstituted aryl group;
R₅ to R₁₀ are the same as or different from each other, and each independently hydrogen; deuterium; a halogen group; a nitrile group; a nitro group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkenyl group; a substituted or unsubstituted aryl group; or a substituted or unsubstituted heterocyclic group;
A₁ and A₄ are the same as or different from each other, and each independently hydrogen, fluorine or chlorine, and at least one of A₁ and A₄ is fluorine or chlorine;
1 is, as a mole fraction, a real number of 0<1<1;
m is, as a mole fraction, a real number of 0<m<1; 1+m=1; and
n is, as a unit repetition number, an integer of 1 to 10,000; 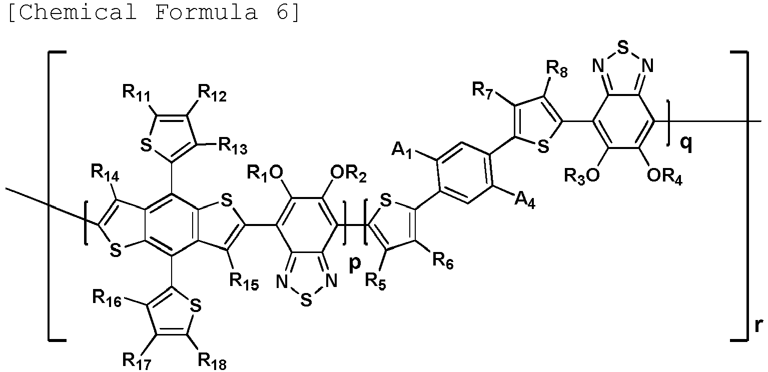
in Chemical Formula 6,
R₁ to R₄ are the same as or different from each other, and each independently a substituted or unsubstituted alkyl group; or a substituted or unsubstituted aryl group;
R₅ to R₈ and R₁₁ to R₁₈ are the same as or different from each other, and each independently hydrogen; deuterium; a halogen group; a nitrile group; a nitro group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkenyl group; a substituted or unsubstituted aryl group; or a substituted or unsubstituted heterocyclic group;
A₁ and A₄ are the same as or different from each other, and each independently hydrogen, fluorine or chlorine, and at least one of A₁ and A₄ is fluorine or chlorine;
p is, as a mole fraction, a real number of 0<p<1;
q is, as a mole fraction, a real number of 0<q<1;
p+q=1; and
r is, as a unit repetition number, an integer of 1 to 10,000,
**characterized in that**
the fullerene-based compound and the non-fullerene-based compound have a mass ratio of 1.2:0.8 to 0.5:1.5 when the polymer of the electron donor includes a unit represented by Chemical Formula 5, and the fullerene-based compound and the non-fullerene-based compound have a mass ratio of 1.2:0.8 to 0.2:1.8 when the polymer of the electron donor includes a unit represented by Chemical Formula 6.

2. The organic solar cell of Claim 1, wherein the fullerene-based compound is any one of the following [6,6]-phenyl-C₆₁-butyric acid methyl ester (PC₆₁BM), [6,6]-phenyl-C₇₁-butyric acid methyl ester (PC₇₁BM), mono-o-quino-dimethane C₆₀ (mono-oQDMC₆₀), bis-o-quino-dimethane C₆₀ (bis-oQDMC₆₀), indene-C₆₀-bis-adduct (ICBA) and bis-[6,6]-phenyl-C₆₁-butyric acid methyl ester (bis-PCBM):

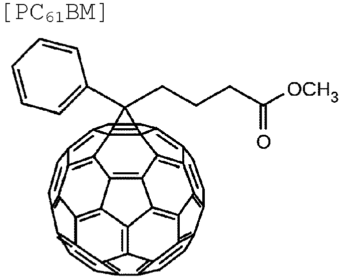

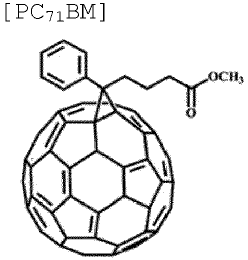

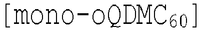

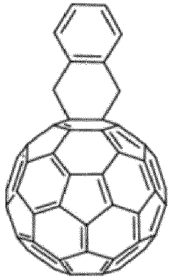

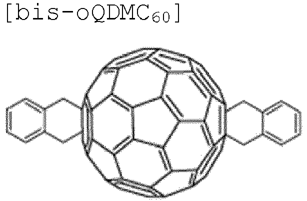

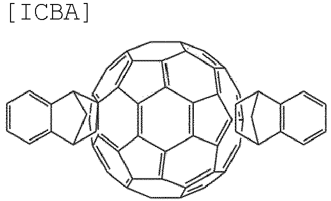

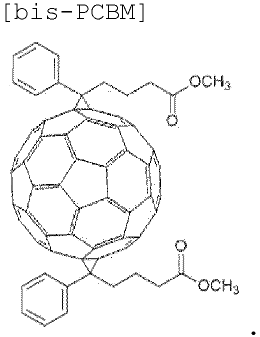

3. The organic solar cell of Claim 1, wherein the non-fullerene-based compound is represented by the following Chemical Formula A: 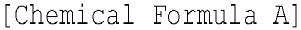 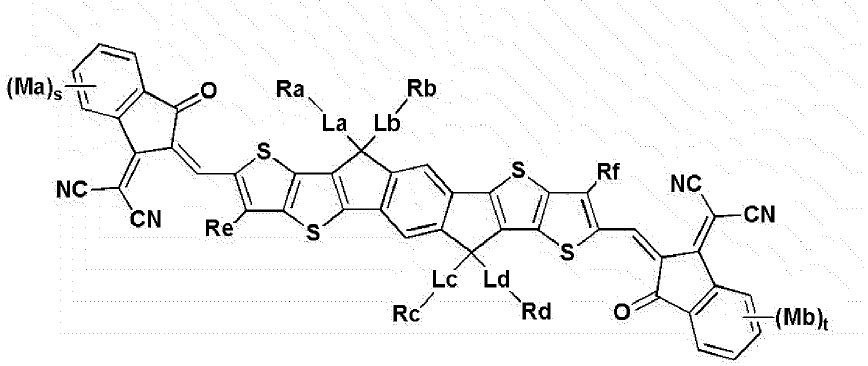 in Chemical Formula A,
Ra to Rf are the same as or different from each other, and each independently hydrogen; or a substituted or unsubstituted alkyl group;
La to Ld are the same as or different from each other, and each independently a substituted or unsubstituted arylene group; or a substituted or unsubstituted divalent heterocyclic group;
Ma and Mb are the same as or different from each other, and each independently hydrogen; a halogen group; or a substituted or unsubstituted alkyl group;
s and t are the same as or different from each other, and each independently an integer of 0 to 2; and
when s or t is each 2, structures in the parentheses are the same as each other.

4. The organic solar cell of Claim 3, wherein the compound represented by Chemical Formula A is any one of the following Chemical Formulae A-1 to A-5: 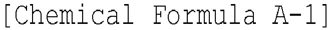 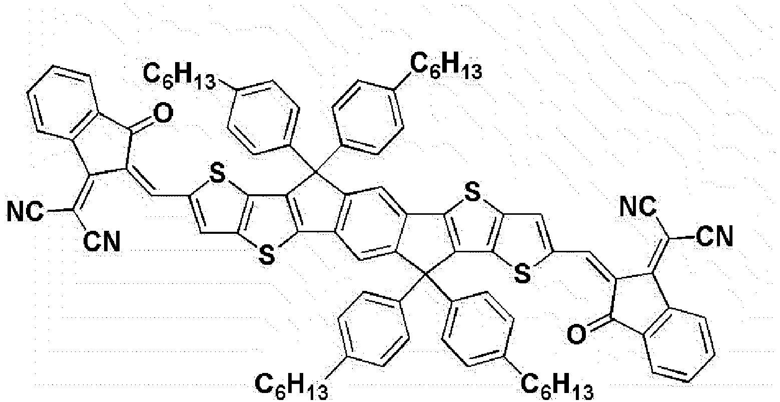 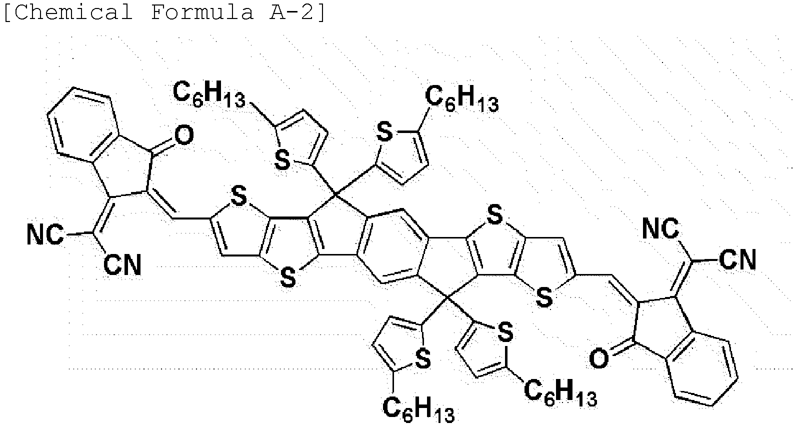 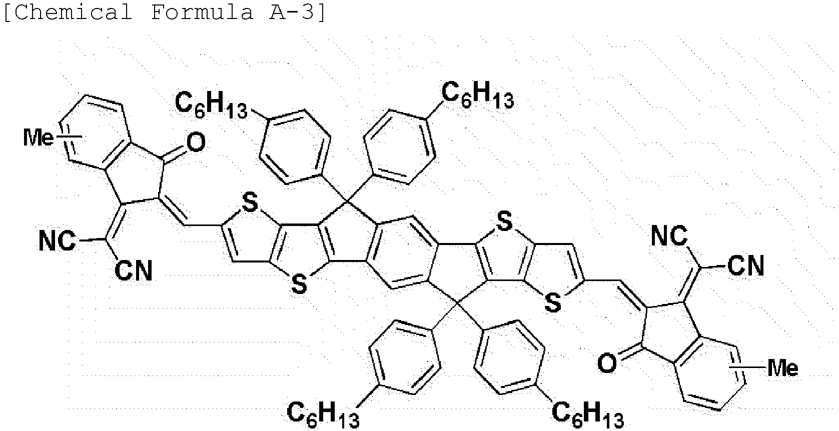 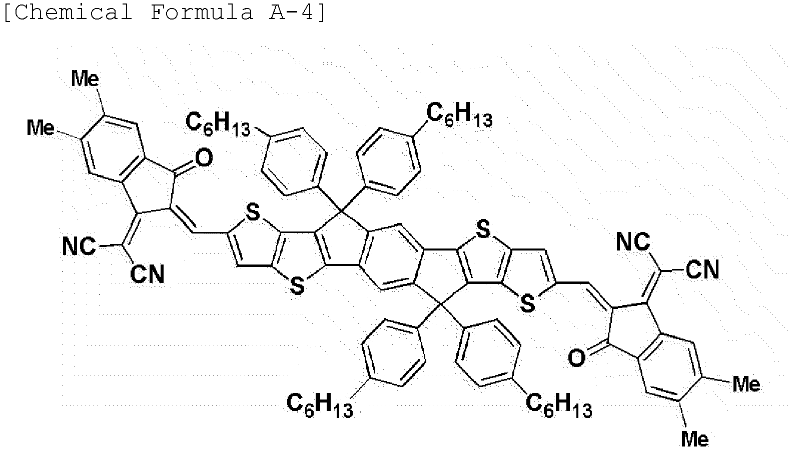 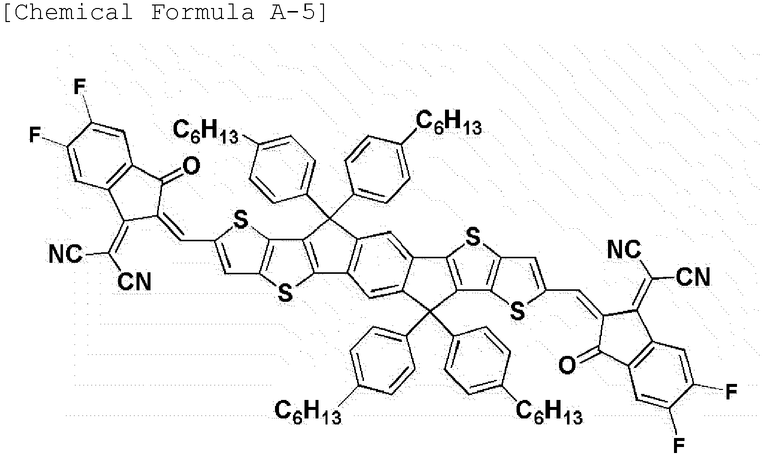 wherein in Chemical Formula A-3 and in Chemical Formula A-4, Me is a methyl group.

5. The organic solar cell of Claim 1, wherein the electron donor and the electron acceptor have a mass ratio of 1:1 to 1:4.

6. The organic solar cell of Claim 1, wherein the electron donor and the electron acceptor form a bulk heterojunction (BHJ) .

7. The organic solar cell of Claim 1, wherein the polymer of the electron donor is a random polymer.

8. The organic solar cell of Claim 1, wherein the polymer of the electron donor has a number average molecular weight of 5,000 g/mol to 1,000,000 g/mol.

## Patentansprüche

1. Organische Solarzelle, umfassend:
eine erste Elektrode (101);
eine zweite Elektrode (105), die der ersten Elektrode gegenüberliegend angeordnet ist; und
eine oder mehrere Schichten aus organischem Material, die zwischen der ersten Elektrode und der zweiten Elektrode angeordnet sind und eine photoaktive Schicht (103) umfassen,
worin die photoaktive Schicht einen Elektronendonor und einen Elektronenakzeptor umfasst,
wobei der Elektronenakzeptor ein Doppelelektronenakzeptor ist, der sowohl eine Fulleren-basierte Verbindung als auch eine Nicht-Fulleren-basierte Verbindung umfasst, und
der Elektronendonor ein Polymer umfasst, das eine durch die folgende chemische Formel 5 dargestellte Einheit oder eine durch die folgende chemische Formel 6 dargestellte Einheit umfasst: 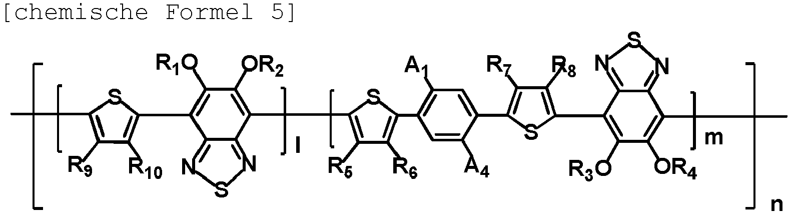
wobei, in der chemischen Formel 5,
R₁ bis R₄ gleich oder voneinander verschieden sind und jeweils unabhängig für eine substituierte oder unsubstituierte Alkylgruppe; oder eine substituierte oder unsubstituierte Arylgruppe stehen;
R₅ bis R₁₀ gleich oder voneinander verschieden sind und jeweils unabhängig für Wasserstoff; Deuterium; eine Halogengruppe; eine Nitrilgruppe; eine Nitrogruppe; eine Hydroxylgruppe; eine substituierte oder unsubstituierte Alkylgruppe; eine substituierte oder unsubstituierte Cycloalkylgruppe; eine substituierte oder unsubstituierte Alkoxygruppe; eine substituierte oder unsubstituierte Aryloxygruppe; eine substituierte oder unsubstituierte Alkenylgruppe; eine substituierte oder unsubstituierte Arylgruppe; oder eine substituierte oder unsubstituierte heterocyclische Gruppe stehen;
A₁ und A₄ gleich oder voneinander verschieden sind und jeweils unabhängig für Wasserstoff, Fluor oder Chlor stehen und mindestens eines aus A₁ und A₄ für Fluor oder Chlor steht;
l als Molenbruch eine reelle Zahl von 0<l<1 ist;
m als Molenbruch eine reelle Zahl von 0<m<1 ist;
l+m=1; und
n als Einheitswiederholungszahl eine ganze Zahl von 1 bis 10.000 ist; 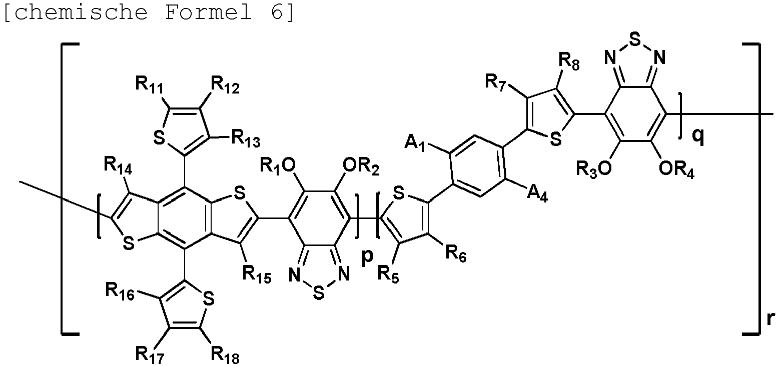
wobei, in der chemischen Formel 6,
R₁ bis R₄ gleich oder voneinander verschieden sind und jeweils unabhängig für eine substituierte oder unsubstituierte Alkylgruppe; oder eine substituierte oder unsubstituierte Arylgruppe stehen;
R₅ bis R₈ und R₁₁ bis R₁₈ gleich oder voneinander verschieden sind und jeweils unabhängig für Wasserstoff; Deuterium; eine Halogengruppe; eine Nitrilgruppe; eine Nitrogruppe; eine Hydroxylgruppe; eine substituierte oder unsubstituierte Alkylgruppe; eine substituierte oder unsubstituierte Cycloalkylgruppe; eine substituierte oder unsubstituierte Alkoxygruppe; eine substituierte oder unsubstituierte Aryloxygruppe; eine substituierte oder unsubstituierte Alkenylgruppe; eine substituierte oder unsubstituierte Arylgruppe; oder eine substituierte oder unsubstituierte heterocyclische Gruppe stehen;
A₁ und A₄ gleich oder voneinander verschieden sind und jeweils unabhängig für Wasserstoff, Fluor oder Chlor stehen und mindestens eines aus A₁ und A₄ für Fluor oder Chlor steht;
p als Molenbruch eine reelle Zahl von 0<p<1 ist;
q als Molenbruch eine reelle Zahl von 0<q<1 ist;
p+q=1; und
r als Einheitswiederholungszahl eine ganze Zahl von 1 bis 10.000 ist,
**dadurch gekennzeichnet, dass** die Fulleren-basierte Verbindung und die Nicht-Fulleren-basierte Verbindung ein Massenverhältnis von 1,2:0,8 bis 0,5:1,5 aufweisen, wenn das Polymer des Elektronendonors eine durch die chemische Formel 5 dargestellte Einheit umfasst, und die Fulleren-basierte Verbindung und die Nicht-Fulleren-basierte Verbindung ein Massenverhältnis von 1,2:0,8 bis 0,2:1,8 aufweisen, wenn das Polymer des Elektronendonors eine durch die chemische Formel 6 dargestellte Einheit umfasst.

2. Organische Solarzelle gemäß Anspruch 1, worin die Fulleren-basierte Verbindung eine der folgenden [6,6]-Phenyl-C₆₁-buttersäuremethylester (PC₆₁BM), [6,6]-Phenyl-C₇₁-buttersäuremethylester (PC₇₁BM), Mono-o-quino-dimethan-C₆₀ (Mono-oQDMC₆₀), Bis-o-quino-dimethan-C₆₀ (Bis-oQDMC₆₀), Indol-C₆₀-bis-Addukt (ICBA) und Bis-[6,6]-phenyl-C₆₁-buttersäuremethylester (Bis-PCBM) ist:

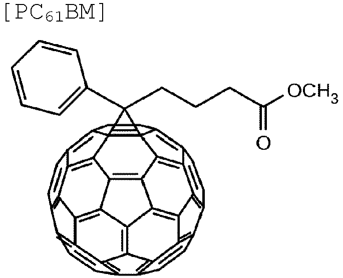

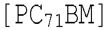

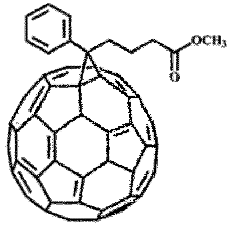

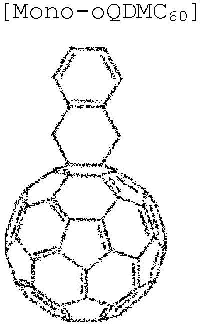

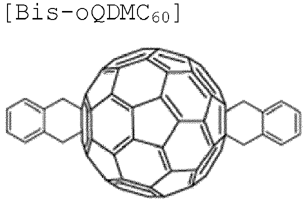

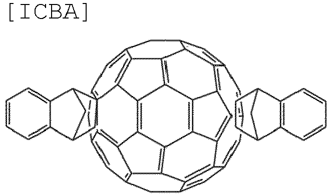

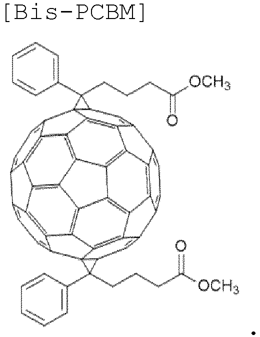

3. Organische Solarzelle gemäß Anspruch 1, worin die Nicht-Fulleren-basierte Verbindung durch die folgende chemische Formel A dargestellt ist: 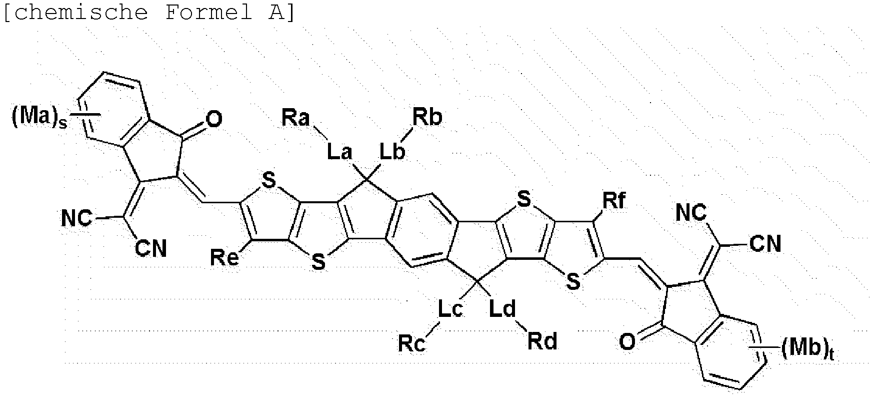 wobei, in der chemischen Formel A,
Ra bis Rf gleich oder voneinander verschieden sind und jeweils unabhängig für Wasserstoff; oder eine substituierte oder unsubstituierte Alkylgruppe stehen;
La bis Ld gleich oder voneinander verschieden sind und jeweils unabhängig für eine substituierte oder unsubstituierte Arylengruppe; oder eine substituierte oder unsubstituierte zweiwertige heterocyclische Gruppe stehen;
Ma und Mb gleich oder voneinander verschieden sind und jeweils unabhängig für Wasserstoff; eine Halogengruppe; oder eine substituierte oder unsubstituierte Alkylgruppe stehen;
s und t gleich oder voneinander verschieden sind und jeweils unabhängig eine ganze Zahl von 0 bis 2 sind; und
wenn s oder t jeweils 2 ist, die Strukturen in den Klammern gleich sind.

4. Organische Solarzelle gemäß Anspruch 3, worin die durch die chemische Formel A dargestellte Verbindung eine der folgenden chemischen Formeln A-1 bis A-5 ist: 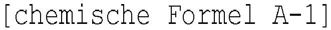 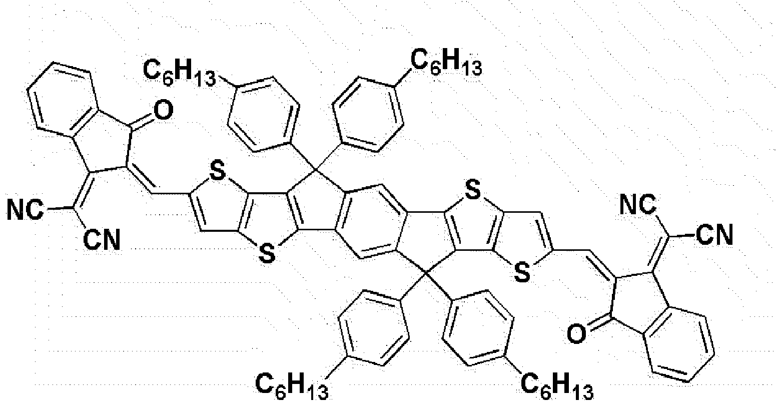 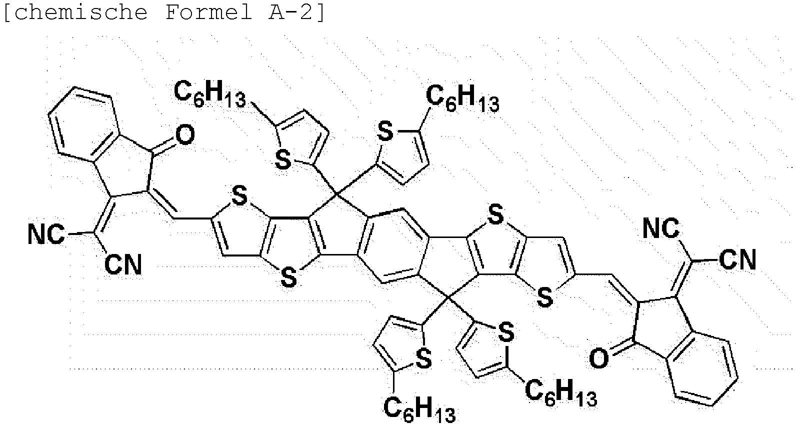 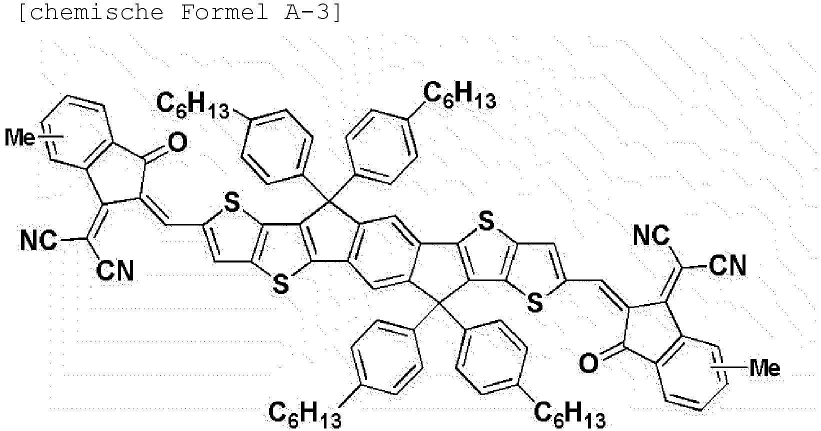 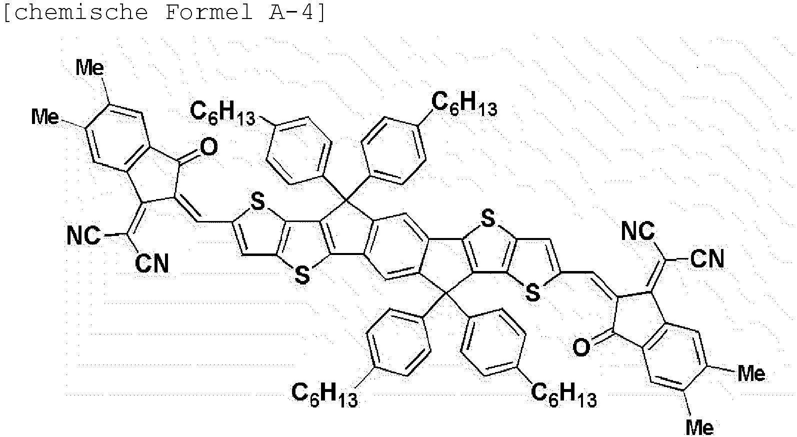 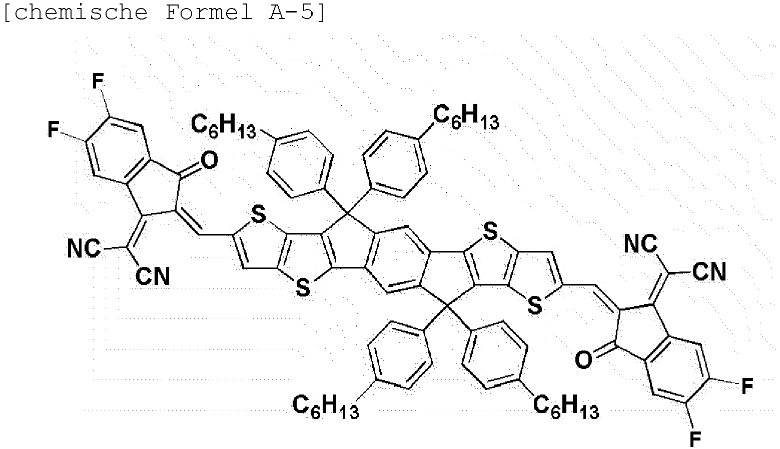 worin in der chemischen Formel A-3 und in der chemischen Formel A-4 Me für eine Methylgruppe steht.

5. Organische Solarzelle gemäß Anspruch 1, worin der Elektronendonor und der Elektronenakzeptor ein Massenverhältnis von 1:1 bis 1:4 aufweisen.

6. Organische Solarzelle gemäß Anspruch 1, worin der Elektronendonor und der Elektronenakzeptor eine Bulk-Heterojunction (BHJ) bilden.

7. Organische Solarzelle gemäß Anspruch 1, worin das Polymer des Elektronendonors ein Random-Polymer ist.

8. Organische Solarzelle gemäß Anspruch 1, worin das Polymer des Elektronendonors ein zahlenmittleres Molekulargewicht von 5.000 g/mol bis 1.000.000 g/mol aufweist.

## Revendications

1. Cellule solaire organique comprenant :
une première électrode (101) ;
une seconde électrode (105) disposée opposée à la première électrode ; et
une ou plusieurs couches de matériau organique disposées entre la première électrode et la seconde électrode et incluant une couche photoactive (103),
dans laquelle la couche photoactive inclut un donneur d'électrons et un accepteur d'électrons,
l'accepteur d'électrons est un accepteur d'électrons double incluant à la fois un composé à base de fullerène et un composé non à base de fullerène, et
le donneur d'électrons inclut un polymère incluant une unité représentée par la formule chimique 5 suivante ou une unité représentée par la formule chimique 6 suivante : 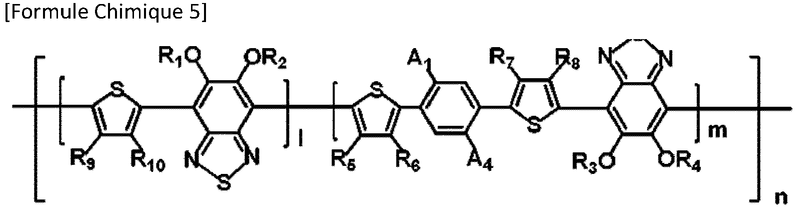
dans la Formule Chimique 5,
les R₁ à R₄ sont identiques ou différents les uns des autres, et chacun indépendamment un groupe alkyle substitué ou non substitué; ou un groupe aryle substitué ou non substitué ;
les R₅ à R₁₀ sont identiques ou différents les uns des autres, et chacun indépendamment de l'hydrogène; du deutérium ; un groupe halogène; un groupe nitrile ; un groupe nitro ; un groupe hydroxyle ; un groupe alkyle substitué ou non substitué ; un groupe cycloalkyle substitué ou non substitué ; un groupe alcoxy substitué ou non substitué ; un groupe aryloxy substitué ou non substitué ; un groupe alcényle substitué ou non substitué; un groupe aryle substitué ou non substitué ; ou un groupe hétérocyclique substitué ou non substitué ;
A₁ et A₄ sont identiques ou différents l'un de l'autre, et chacun indépendamment de l'hydrogène, du fluor ou du chlore, et au moins l'un de A₁ et A₄ est du fluor ou du chlore ;
l est, en tant que fraction molaire, un nombre réel de 0<l<1 ;
m est, en tant que fraction molaire, un nombre réel de 0<m<1 ;
l + m = 1 ; et
n est, en tant que nombre de répétitions d'unité, un nombre entier de 1 à 10 000 ; 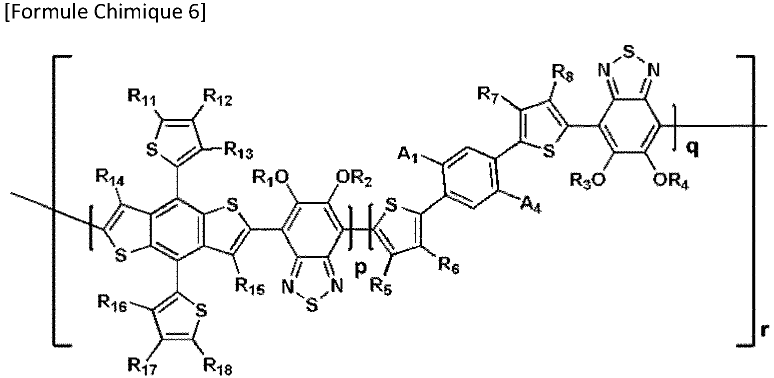
dans la Formule Chimique 6,
les R₁ à R₄ sont identiques ou différents les uns des autres, et chacun indépendamment un groupe alkyle substitué ou non substitué; ou un groupe aryle substitué ou non substitué ;
R₅ à R₈ et R₁₁ à R₁₈ sont identiques ou différents les uns des autres, et chacun indépendamment de l'hydrogène; du deutérium ; un groupe halogène; un groupe nitrile ; un groupe nitro ; un groupe hydroxyle ; un groupe alkyle substitué ou non substitué ; un groupe cycloalkyle substitué ou non substitué ; un groupe alcoxy substitué ou non substitué ; un groupe aryloxy substitué ou non substitué ; un groupe alcényle substitué ou non substitué; un groupe aryle substitué ou non substitué ; ou un groupe hétérocyclique substitué ou non substitué ;
_{A1}et A₄ sont identiques ou différents l'un de l'autre, et chacun indépendamment de l'hydrogène, du fluor ou du chlore, et au moins l'un de A₁ et A₄ est du fluor ou du chlore ;
p est, en tant que fraction molaire, un nombre réel de 0<p<1 ;
q est, en tant que fraction molaire, un nombre réel de 0<q<1 ;
p+q=1 ; et
r est, en tant que nombre de répétitions d'unité, un nombre entier de 1 à 10 000,
**caractérisé en ce que** le composé à base de fullerène et le composé non à base de fullerène présentent un rapport massique de 1,2:0,8 à 0,5:1,5 lorsque le polymère du donneur d'électrons inclut une unité représentée par la formule chimique 5, et le composé à base de fullerène et le composé non à base de fullerène présente un rapport massique de 1,2:0,8 à 0,2:1,8 lorsque le polymère du donneur d'électrons inclut une unité représentée par la formule chimique 6.

2. Cellule solaire organique selon la revendication 1, dans laquelle le composé à base de fullerène est l'un quelconque des suivants : ester méthylique d'acide [6,6]-phényl-C₆₁-butyrique (PC₆₁BM), ester méthylique d'acide [6,6]-phényl-C₇₁-butyrique (PC₇₁BM), mono-o-quino-diméthane C₆₀ (mono-oQDMC₆₀), bis-o-quino-diméthane C₆₀ (bis-oQDMC₆₀), indène-C₆₀-bis-adduit (ICBA) et ester méthylique d'acide bis-[6, 6]-phényl-C₆₁-butyrique (bis-PCBM) :

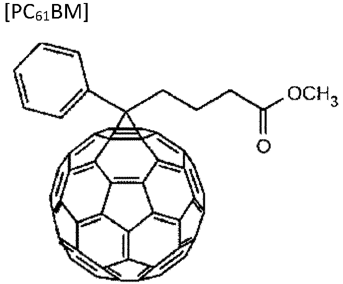

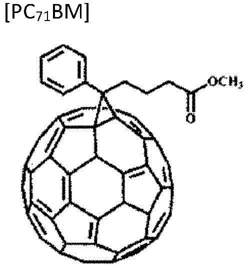

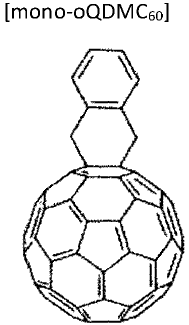

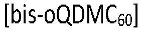

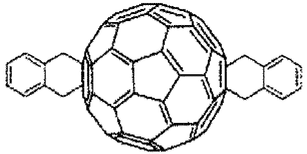

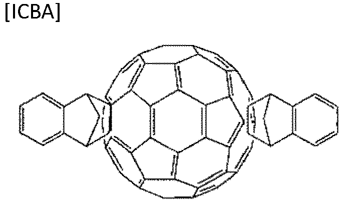

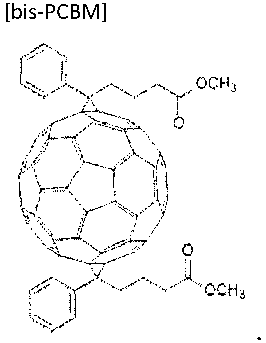

3. Cellule solaire organique selon la revendication 1, dans laquelle le composé non à base de fullerène est représenté par la formule chimique A suivante : 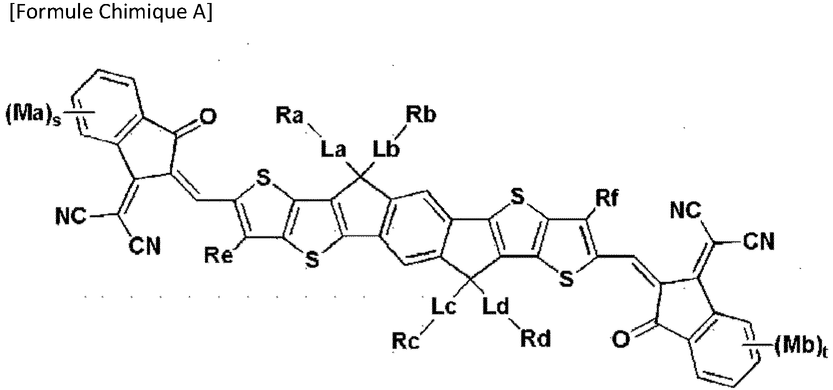 dans la Formule Chimique A,
les Ra à Rf sont identiques ou différents les uns des autres, et chacun indépendamment de l'hydrogène ; ou un groupe alkyle substitué ou non substitué ;
les La à Ld sont identiques ou différents les uns des autres, et chacun indépendamment un groupe arylène substitué ou non substitué ; ou un groupe hétérocyclique divalent substitué ou non substitué ;
Ma et Mb sont identiques ou différents l'un de l'autre, et chacun indépendamment de l'hydrogène ; un groupe halogène ; ou un groupe alkyle substitué ou non substitué ;
s et t sont identiques ou différents l'un de l'autre, et chacun indépendamment un nombre entier de 0 à 2 ; et
lorsque s ou t est chacun 2, les structures dans les parenthèses sont identiques les unes aux autres.

4. Cellule solaire organique selon la revendication 3, dans laquelle le composé représenté par la Formule Chimique A est l'une quelconque des Formules Chimiques A-1 à A-5 suivantes : 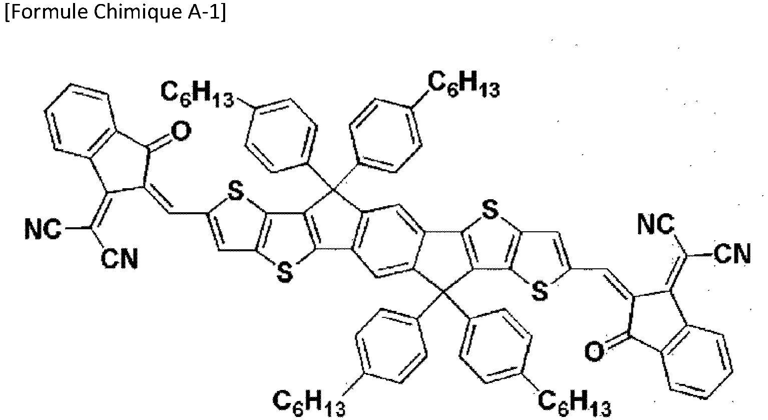 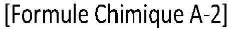 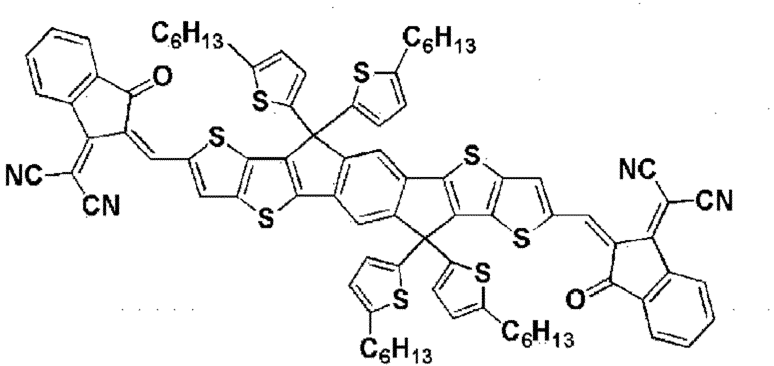 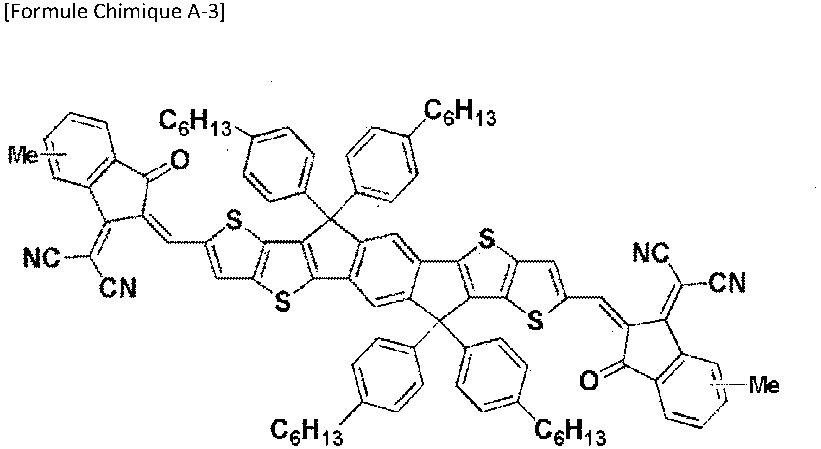 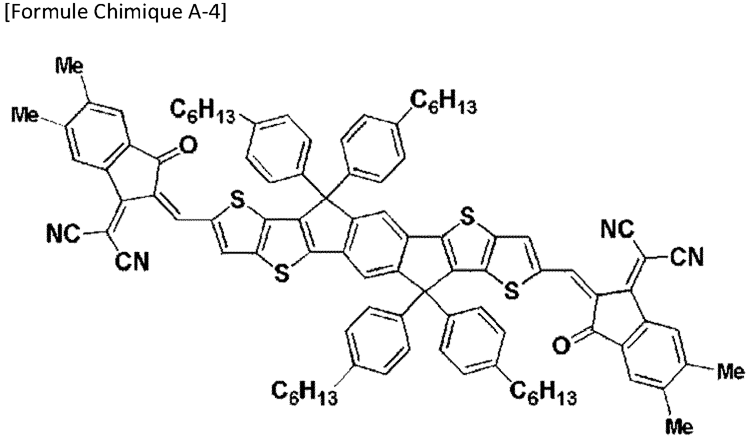 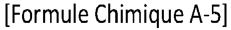 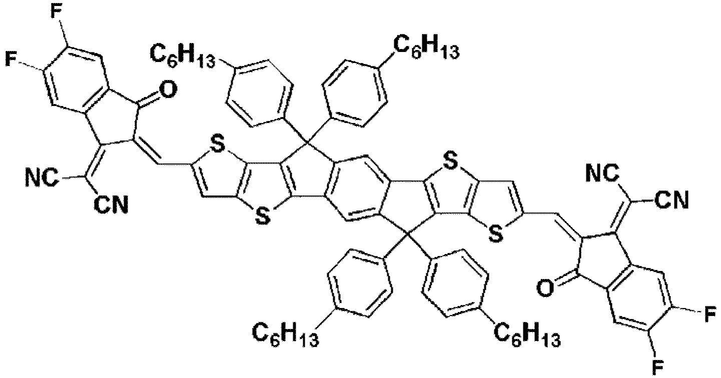 dans laquelle dans la Formule Chimique A-3 et dans la Formule Chimique A-4, Me est un groupe méthyle.

5. Cellule solaire organique selon la revendication 1, dans laquelle le donneur d'électrons et l'accepteur d'électrons présentent un rapport massique de 1:1 à 1:4.

6. Cellule solaire organique selon la revendication 1, dans laquelle le donneur d'électrons et l'accepteur d'électrons forment une hétérojonction en volume (BHJ).

7. Cellule solaire organique selon la revendication 1, dans laquelle le polymère du donneur d'électrons est un polymère aléatoire.

8. Cellule solaire organique selon la revendication 1, dans laquelle le polymère du donneur d'électrons présente un poids moléculaire moyen en nombre de 5 000 g/mol à 1 000 000 g/mol.
